(19) **Europäisches Patentamt / European Patent Office / Office européen des brevets**

(11) **EP 3 556 016 B1**

(12) **FASCICULE DE BREVET EUROPEEN**

(45) Date de publication et mention
de la délivrance du brevet:
**07.04.2021  Bulletin 2021/14**

(51) Int Cl.:
***H03K 17/975*** *(2006.01)*    ***H03K 17/955*** *(2006.01)*
***H03K 17/96*** *(2006.01)*

(21) Numéro de dépôt: **17816490.1**

(86) Numéro de dépôt international:
**PCT/EP2017/080162**

(22) Date de dépôt: **23.11.2017**

(87) Numéro de publication internationale:
**WO 2018/108475 (21.06.2018 Gazette 2018/25)**

(54) **DISPOSITIF ET PROCEDE DE DETECTION DE L'APPROCHE ET/OU DE CONTACT, ET DE L'APPUI D'UN OBJET, RELATIVEMENT A UNE SURFACE DE DETECTION**

VORRICHTUNG UND VERFAHREN ZUR ERKENNUNG DER ANNÄHERUNG UND/ODER DES KONTAKTES UND DES DRUCKS EINES OBJEKTES IN RELATION ZU EINER DETEKTIONSOBERFLÄCHE

DEVICE AND METHOD FOR DETECTING THE APPROACH AND/OR CONTACT, AND THE PRESSURE OF AN OBJECT IN RELATION TO A DETECTION SURFACE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.12.2016  FR 1662613**

(43) Date de publication de la demande:
**23.10.2019  Bulletin 2019/43**

(73) Titulaire: **Fogale Nanotech**
**30900 Nîmes (FR)**

(72) Inventeurs:
• **NEEL, Christian**
  **30900 Nîmes (FR)**
• **OSSART, Frédéric**
  **30980 Langlade (FR)**
• **ROZIERE, Didier**
  **30900 Nîmes (FR)**

(74) Mandataire: **IPAZ**
**Parc Les Algorithmes, Bâtiment Platon**
**CS 70003 Saint-Aubin**
**91192 Gif-sur-Yvette Cedex (FR)**

(56) Documents cités:
**WO-A1-2013/093326      WO-A2-2015/144474**
**JP-B2- 5 888 686**

## Description

### Domaine technique

La présente invention concerne un dispositif de détection d'une part de l'approche d'un objet vers une surface, et/ou du contact dudit objet avec ladite surface, et d'autre part de l'appui dudit objet sur ladite surface. Elle concerne également un procédé mettant en œuvre un tel dispositif.

Le domaine de l'invention est, de manière non limitative, celui des interfaces de détection capacitive d'objets pour appareil électronique, permettant audit appareil de détecter les objets environnants, en particulier dans le domaine de la robotique.

### Etat de la technique

Les appareils électroniques interagissent avec leur environnement de manière de plus en plus autonome. Cette interaction autonome nécessite, le plus souvent, la possibilité de détecter les objets/personnes se trouvant à proximité ou au contact de l'appareil, en particulier lorsque ledit appareil est un robot, qu'il soit mobile ou non. Une telle détection d'approche et de contact est réalisée grâce à une surface de détection équipée de capteurs de détection d'approche et/ou de contact, en particulier capacitifs.

Pour parfaire cette interaction, il parait nécessaire de détecter, en plus de l'approche et du contact, un appui, une pression ou une force exercée par un objet sur une surface de détection de l'appareil. Il existe actuellement des capteurs de détection d'un appui sur une surface de détection d'un appareil.

Cependant, l'ajout d'un tel capteur de détection d'appui dans une surface de détection, déjà équipée de capteurs d'approche et de contact, s'avère coûteux, encombrant et complexe. De plus, la juxtaposition de capteurs dédiés à la détection d'approche et de contact et de capteurs dédiés à la détection d'un appui créé des interférences mutuelles dégradant le fonctionnement et l'efficacité de ces capteurs.

Un but de la présente invention est de remédier aux inconvénients précités.

Un autre but de la présente invention est de proposer un unique dispositif capteur permettant de détecter d'une part l'approche et/ou le contact, et d'autre part l'appui d'un objet sur une surface de détection.

Encore un autre but de la présente invention est de proposer un unique dispositif capteur permettant de détecter d'une part l'approche et/ou le contact, et d'autre part un appui, moins encombrant, moins coûteux et moins complexe comparé à une juxtaposition de deux capteurs existants l'un dédié à la détection d'approche et de contact et l'autre dédié à la détection d'appui

Le document WO2013/093326 A1 représente un exemple de l'état de la technique.

### Exposé de l'invention

Au moins un de ces buts est atteint avec un dispositif de détection d'un objet par rapport à une surface de détection selon la revendication 1.

La capacité électrode-objet est représentative d'une approche et/ou d'un contact de l'objet avec la surface de détection. La capacité électrode-garde est représentative d'un appui, d'une pression et/ou d'une force exercés par ledit objet sur ladite surface de détection. Ces appui, pression ou force peuvent être exercés de manière axiale (perpendiculairement à la surface de détection), ou comprendre une composante tangentielle de cisaillement.

Suivant les modes de réalisation de l'invention, les moyens de polarisation électrique des électrodes comprennent, de manière non limitative, au moins l'un des éléments suivants : au moins une source électrique, au moins un commutateur électrique, au moins un moyen de commande agencé pour commander l'au moins une source électrique et/ou l'au moins un commutateur électrique. Un moyen de commande agencé pour commander une source électrique peut par exemple commander cette source pour qu'elle génère un signal ou une tension, et/ou pour modifier le signal généré, et/ou pour arrêter la source de sorte qu'elle se comporte comme un court-circuit ou un composant passif. Pour cela, ce moyen de commande peut par exemple agir sur un signal d'horloge ou une tension de référence.

Un potentiel électrique peut être appliqué à des électrodes, de manière non limitative, en reliant électriquement ces électrodes à ce potentiel, ou en soumettant ces électrodes, directement ou par l'intermédiaire de composants électroniques et/ou de pistes ou de fils de liaison et/ou de tout autre moyen de couplage électrique (champ électrique, induction), à ce potentiel électrique ou à une source générant ce potentiel électrique.

De même, dans le cadre de l'invention, polariser électriquement des électrodes à un potentiel électrique peut signifier par exemple soumettre ces électrodes au potentiel électrique, ou appliquer le potentiel électrique aux électrodes.

On définit un potentiel de masse comme un potentiel de référence pour l'électronique ou une partie de l'électronique. Un potentiel de masse peut également correspondre à une terre ou un potentiel de terre.

Les potentiels électriques peuvent être définis, sans perte de généralité, par rapport à une référence électrique qui peut être le point de référence de la source qui les génèrent, ou un potentiel de référence général tel qu'un potentiel de masse.

Un potentiel alternatif peut être défini comme un potentiel variable dans le temps avec au moins une composante fréquentielle à une fréquence non-nulle.

Le premier potentiel peut ainsi être défini (ou référencé), de manière non limitative, par rapport au potentiel de masse. Dans ce cas, le premier potentiel peut correspondre également à une différence de potentiel par rapport au potentiel de masse considéré comme nul.

Pour appliquer la différence de potentiel électrique alternative (ou la différence de potentiel électrique alternative), les moyens de polarisation sont agencés pour appliquer, respectivement, un troisième potentiel à l'électrode de mesure, et un quatrième potentiel à l'électrode de garde. Ces troisièmes et quatrièmes potentiels peuvent être définis (ou référencé), de manière non limitative, par rapport au potentiel de masse. La différence de potentiel électrique alternative correspond donc à la différence entre ces troisièmes et quatrièmes potentiels, ou, en d'autres termes, à un potentiel différentiel appliqué entre l'électrode de mesure et l'électrode de garde.

De manière générale, les potentiels électriques appliqués aux électrodes de mesure et de garde pour générer le premier potentiel alternatif et la différence de potentiel alternative peuvent être de toutes formes, et notamment sinusoïdale, carrée, triangulaire, .... Ils peuvent être générés de manière directe, ou en utilisant des techniques de modulation de largeur d'impulsions (PWM).

Dans le cadre de la présente invention, des premiers potentiels alternatifs appliqués à des électrodes peuvent être considérés comme sensiblement identiques lorsqu'ils ne génèrent pas de mesure de capacité électrode-garde exploitable en sortie de l'électronique de mesure. On peut notamment citer comme exemples de premiers potentiels électriques alternatifs identiques ou sensiblement identiques :

- des potentiels alternatifs ayant une même forme temporelle (sinusoïdale, carrée, triangulaire, ...), une même amplitude de variation et une même phase (ou en d'autres termes variant de manière synchrone) ;
- des potentiels alternatifs qui comportent au moins une composante spectrale identique en amplitude et en phase à au moins une fréquence de travail.

Il est à noter que les électrodes peuvent être polarisées, ou soumises à un potentiel global, correspondant à une superposition d'un premier potentiel électrique alternatif identique ou sensiblement identique pour chaque électrode et d'autres potentiels avec d'autres composantes éventuellement différentes pour chaque électrode mais qui ne génèrent pas de mesure de capacité électrode-garde exploitable en sortie de l'électronique de mesure.

Ainsi, suivant les modes de mise en œuvre de l'électronique de mesure, la capacité électrode objet peut être mesurée en appliquant respectivement aux électrodes de mesure et de garde des potentiels globaux comprenant des premiers potentiels électriques alternatifs identiques, et des composantes différentes telles qu'une composante continue, ou une composante fréquentielle qui ne se trouve pas dans la bande passante de détection de l'électronique de mesure, ou encore une composante avec une forme d'onde orthogonale à celle des premiers potentiels électriques alternatifs.

Ainsi, le dispositif selon l'invention permet de mesurer, avec une seule électronique de mesure et un ensemble de deux électrodes (au moins), d'une part un premier signal dépendant (ou représentatif) d'une première information qui est l'approche et/ou le contact d'un objet avec la surface de détection, et d'autre part un deuxième signal dépendant (ou représentatif) d'une deuxième information qui est l'appui, ou la pression, exercée par l'objet sur la surface de détection. On peut ainsi obtenir des mesures d'approche et de contact d'une part, et de pression d'autre part, de manière distinctes et non ambiguës.

Par conséquent, le dispositif selon l'invention est moins coûteux, moins encombrant et moins complexe à mettre en œuvre comparé à une juxtaposition de deux capteurs dédiés, l'un à la détection d'approche et de contact, et l'autre à la détection d'appui. De plus, le dispositif selon l'invention présente une meilleure performance en détection comparé à une configuration utilisant deux capteurs indépendants pouvant interférer l'un sur l'autre.

Avantageusement, le premier signal relatif à la capacité électrode-objet et le deuxième signal relatif à la capacité électrode-garde peuvent être mesurés, par l'électronique de mesure, au niveau d'un même point de mesure.

Ainsi, la mise en œuvre du dispositif selon l'invention est simplifiée.

Suivant les modes de réalisation, le premier signal dépendant de la capacité électrode-objet et le deuxième signal dépendant de la capacité électrode-garde peuvent être mesurés simultanément, en appliquant aux électrodes simultanément le premier potentiel électrique alternatif et la différence de potentiel alternative, ou séquentiellement.

Suivant des modes de réalisation, les moyens de polarisation électrique des électrodes peuvent être agencés de sorte à générer un premier potentiel électrique alternatif et une différence de potentiel électrique satisfaisant au moins l'un des critères suivants :

- le premier potentiel électrique alternatif et la différence de potentiel électrique comprennent respectivement au moins une composante fréquentielle à une fréquence différente ;
- le premier potentiel électrique alternatif et la différence de potentiel électrique comprennent des signaux orthogonaux entre eux.

Ainsi, on peut générer un premier signal électrique dépendant de la capacité électrode-objet et un deuxième signal électrique dépendant de la capacité électrode-garde qui sont codés différemment, et donc qui peuvent être distingués même s'ils sont générés simultanément et mesurés sur la même électrode de mesure.

Lorsqu'on met en œuvre un premier potentiel électrique alternatif et une différence de potentiel électrique avec au moins une composante fréquentielle à une fréquence différente, on peut réaliser un multiplexage fréquentiel et démoduler séparément le premier signal électrique et le second signal électrique qui en découlent à des fréquences de travail différentes.

On définit des signaux orthogonaux comme étant des signaux dont le produit scalaire de deux quelconques de ces signaux sur un nombre d'échantillons ou une durée prédéterminée est nul ou quasiment nul (par rapport au module de ces signaux, c'est-à-dire au produit scalaire de ces signaux avec eux-mêmes). En outre, on utilise la définition classique d'un produit scalaire dans un espace vectoriel muni d'une base orthonormée comme étant la somme des produits terme-à-terme des échantillons des signaux dans la durée prédéterminée.

La mise en œuvre d'un premier potentiel électrique alternatif et d'une différence de potentiel électrique avec des signaux orthogonaux entre eux, associée à une détection synchrone comme expliqué plus loin, permet de démoduler le premier signal électrique et le second signal électrique qui en découlent de manière indépendante, en minimisant les effets de diaphonies (crosstalk) entre eux.

Il est à noter que des signaux à des fréquences différentes ne sont pas orthogonaux entre eux dans le cas général. Ils peuvent toutefois être orthogonaux entre eux s'ils ont des fréquences qui correspondent à des multiples entiers les unes des autres.

Par ailleurs, des signaux orthogonaux peuvent être des signaux de même fréquence ou plus généralement de même forme, de même amplitude mais en quadrature de phase.

Suivant des modes de réalisation, le dispositif selon l'invention peut comprendre une électronique de mesure avec au moins un moyen de démodulation mettant en œuvre l'un au moins des éléments suivants :

- un démodulateur synchrone ;
- un détecteur d'amplitude ;
- un démodulateur numérique.

De manière générale, un démodulateur synchrone peut se modéliser par (ou comprendre) un multiplicateur qui effectue une multiplication du signal de mesure avec le signal de porteuse et un filtre passe-bas.

Le signal de porteuse peut être, ou comprendre, respectivement :

- le premier potentiel électrique alternatif, pour la démodulation du premier signal électrique ;
- la différence de potentiel électrique alternative, pour la démodulation du premier signal électrique.

La mise en œuvre de démodulateurs synchrones permet de démoduler des signaux multiplexés en fréquence à des fréquences de travail différentes, et/ou de démoduler des signaux orthogonaux entre eux.

Un détecteur d'amplitude (ou démodulateur asynchrone) peut se modéliser par (ou comprendre) un élément de redressement tel qu'un redresseur à diodes, des commutateurs à switchs ou un détecteur quadratique, et un filtre passe-bas. Il permet d'obtenir l'amplitude du signal de mesure modulé issu du détecteur de courant.

La mise en œuvre de détecteurs d'amplitude permet de démoduler des signaux multiplexés en fréquence à des fréquences de travail différentes.

Les moyens de démodulation peuvent également comprendre des filtres passe-bande ou passe-bas anti-repliement placés avant la démodulation.

Bien entendu, les moyens de démodulation peuvent être réalisés sous forme numérique et/ou analogique. Ils peuvent notamment comprendre un convertisseur analogique-numérique et un microprocesseur et/ou un FPGA qui effectue numériquement une démodulation synchrone, une détection d'amplitude ou toute autre opération de démodulation.

Suivant des modes de réalisation, le dispositif selon l'invention peut comprendre un premier moyen de démodulation exploitant le premier potentiel électrique alternatif pour déterminer le premier signal, et un second moyen de démodulation exploitant la différence de potentiel électrique alternative pour déterminer le deuxième signal.

Dans ce cas, le premier moyen de démodulation peut utiliser comme signal de porteuse le premier potentiel électrique alternatif pour la démodulation du premier signal électrique, et le second moyen de démodulation peut utiliser comme signal de porteuse la différence de potentiel électrique alternative pour la démodulation du second signal électrique.

Pour autant que le premier potentiel électrique alternatif et la différence de potentiel électrique alternative soient choisis judicieusement comme expliqué précédemment, le premier signal électrique et le second signal électrique peuvent être démodulés simultanément, en parallèle.

Suivant des modes de réalisation, les moyens de polarisation électrique des électrodes peuvent être agencés pour générer une différence de potentiel électrique alternative avec une amplitude différente de l'amplitude du premier potentiel électrique alternatif.

En particulier, les moyens de polarisation électrique des électrodes peuvent être agencés pour générer une différence de potentiel électrique alternative avec une amplitude inférieure à l'amplitude du premier potentiel électrique alternatif. La différence de potentiel électrique alternative peut par exemple avoir une amplitude inférieure à 1/2, ou 1/5, ou 1/10, ou 1/100 de l'amplitude du premier potentiel électrique alternatif. Une telle différence d'amplitude permet de compenser la différence de valeurs entre la capacité électrode-garde et la capacité électrode-objet (la capacité électrode-garde peut avoir une valeur supérieure, par exemple de l'ordre de 2 fois à 100 fois plus élevée, que la capacité électrode-objet), et détecter les deux capacités dans de bonnes conditions avec l'électronique de mesure. Il est à noter qu'un résultat similaire peut être obtenu avec une différence de potentiel électrique alternative avec une amplitude supérieure à l'amplitude du premier potentiel électrique alternatif, dans la mesure où c'est la différence de potentiels obtenue qui produit l'effet de compensation.

Suivant des modes de réalisation, les moyens de polarisation électrique des électrodes peuvent comprendre une première source électrique référencée en entrée au potentiel de masse et fournissant le premier potentiel électrique alternatif.

En d'autres termes, la première source électrique génère entre ses bornes une différence de potentiel égale au premier potentiel électrique alternatif.

Suivant des modes de réalisation, la première source électrique peut être électriquement reliée en sortie à l'au moins une électrode de garde, et les moyens de polarisation électrique des électrodes peuvent comprendre en outre un premier commutateur de source permettant de polariser électriquement l'au moins une électrode de mesure soit au premier potentiel électrique alternatif, soit au potentiel de masse.

Ainsi, dans une première position du premier commutateur de source, on applique le premier potentiel électrique alternatif aux électrodes de mesure et aux électrodes de garde, ce qui permet de mesurer le premier signal électrique.

Dans une seconde position du premier commutateur de source, on applique entre les électrodes de mesure et de garde une différence de potentiel électrique alternative qui correspond dans ce cas au premier potentiel électrique alternatif, et qui permet de mesurer le deuxième signal électrique.

Suivant des modes de réalisation, les moyens de polarisation électrique des électrodes peuvent comprendre une deuxième source électrique fournissant entre ses bornes la différence de potentiel électrique alternative, laquelle deuxième source de tension étant référencée en entrée au premier potentiel électrique alternatif, et étant agencée en sortie selon l'une des configurations suivantes :

- de sorte à appliquer la différence de potentiel électrique alternative à l'au moins une électrode de garde ;
- de sorte à appliquer la différence de potentiel électrique alternative à l'au moins une électrode de mesure.

Suivant des modes de réalisation, les moyens de polarisation électrique des électrodes peuvent comprendre au moins l'un des commutateurs suivants :

- un premier commutateur agencé de sorte à permettre d'appliquer à l'au moins une électrode de garde et à l'au moins une électrode de mesure, soit le potentiel de masse, soit le premier potentiel électrique alternatif (issu par exemple de la première source électrique) ;
- un second commutateur agencé de sorte à permettre d'appliquer entre l'au moins une électrode de garde et l'au moins une électrode de mesure, soit la différence de potentiel électrique alternative (telle que générée par exemple par la deuxième source électrique), soit une différence de potentiel nulle ou sensiblement nulle.

Le premier et le second commutateur peuvent comprendre tous types de commutateurs électriques commandables, par exemple à base de relais électromécaniques ou de transistors.

Le premier commutateur peut comprendre une sortie pouvant être reliée sélectivement à une entrée reliée au potentiel de masse, ou à une entrée reliée à la sortie de la première source électrique.

Le second commutateur peut comprendre une sortie pouvant être reliée sélectivement à une entrée reliée à la sortie de la première source électrique ou à la sortie du premier commutateur le cas échéant, ou à une entrée reliée à la sortie de la deuxième source électrique.

Le dispositif selon l'invention peut en outre comprendre au moins un module de calcul configuré pour :

- déterminer une distance ou un contact entre l'objet et la surface de détection en fonction du premier signal (et/ou une vitesse, une trajectoire, un mouvement, un geste,...) ; et/ou
- déterminer une pression appliquée par ledit objet sur la surface de détection en fonction du deuxième signal.

L'au moins un module de calcul peut déterminer ladite distance ou contact, respectivement ladite pression, par calcul ou par comparaison avec une table de référence préalablement établi.

L'au moins un module de calcul peut déterminer ladite distance ou contact directement en fonction du premier signal mesuré ou d'une version numérisée dudit signal, ou d'une valeur de capacité électrode-objet déduite dudit premier signal, mesuré ou numérisé.

L'au moins un module de calcul peut déterminer ladite pression directement en fonction du deuxième signal mesuré ou d'une version numérisée dudit signal, ou d'une valeur de capacité électrode-garde déduite dudit deuxième signal, mesuré ou numérisé.

Suivant des modes de réalisation, le dispositif selon l'invention peut comprendre au moins une électrode de mesure et au moins une électrode de garde séparées par une couche élastiquement compressible, en particulier localement, comprenant ou formée par, un matériau diélectrique.

Le matériau diélectrique peut par exemple comprendre :

- un fluide diélectrique, tel que de l'huile ;
- un polymère diélectrique, tel qu'un polymère à base de silicone ; ou
- une mousse diélectrique, telle qu'une mousse en polyester ou en silicone.

Bien entendu, le matériau diélectrique peut comprendre ou être composé de plusieurs matériaux, comme par exemple des matériaux structuré (polymère/air) pour diminuer la raideur.

Suivant des modes de réalisation, le dispositif selon l'invention peut comprendre une ou des électrodes de mesure et/ou de garde réalisées par exemple :

- à partir d'un dépôt d'encre conductrice, déposée par exemple avec un procédé de sérigraphie ou de jet d'encre, sur une surface de matériau diélectrique ;
- à partir de couches de matériaux métalliques comme du cuivre, argent, ou d'autres matériaux conducteurs tels que du carbone ou des oxydes métalliques (Oxyde d'Indium Etain ou ITO, oxyde de zinc ou ZnO) déposées par un procédé de dépôt sous vide ou gravées par un procédé de gravure ;
- à partir de circuit imprimé ou similaire, rigide, semi rigide ou souple (diélectrique epoxy, polyimide, PET....), avec une seule ou plusieurs couches de métal... ;
- avec des polymères conducteurs ;
- sous la forme de tissu ou de couches de tissu, avec des fils en matériau conducteur (métal, ...) tissés ou tricotés... ;
- A partir de matériau liquides (comme de l'eau) intégrés dans un matériau isolant étanche.

Suivant des modes de réalisation, le dispositif selon l'invention peut comprendre une ou des électrodes de mesure et/ou de garde transparentes. De telles électrodes peuvent être réalisées par exemple avec un dépôt d'oxyde conducteur transparent, tel que par exemple un Oxyde d'Indium Etain (ou ITO), sur une couche de polymère diélectrique transparent tel que du Polytéréphtalate d'éthylène (PET).

Les pistes de liaison de l'une au moins des électrodes de mesure et de garde peuvent être également être transparente.

La couche élastiquement compressible de séparation peut également être réalisée en matériau diélectrique transparent. A cet effet, elle peut être réalisée, par exemple, en plastique souple transparent ou en PolyDiMethylSiloxane (ou PDMS).

Suivant des modes de réalisation, le dispositif selon l'invention peut comprendre au moins une électrode de mesure disposée sur, ou dans, ou sous, un support, réalisé en un matériau souple, tel qu'un tissu (par exemple une structure tissée ou tricotée), placé au-dessus et à distance d'au moins une électrode de garde, et se déformant au moins localement lorsqu'une pression est exercée sur ledit support.

Dans ce cas, la ou les électrodes de mesure peuvent être réalisées par exemple dans un tissu, ou sous forme de tissu ou de couches de tissu, avec des fils en matériau conducteur (métal, ...) tissés ou tricotés....

Suivant des modes de réalisation, le dispositif selon l'invention peut comprendre plusieurs électrodes de mesures.

Le dispositif selon l'invention peut en particulier comprendre une pluralité d'électrodes de mesure distribuées dans le plan de la surface de détection.

Les électrodes de mesure peuvent être disposées en particulier selon une disposition matricielle.

Suivant des modes de réalisation, le dispositif selon l'invention peut comprendre une ou des électrodes de garde agencées selon au moins l'une des configurations suivantes :

- au moins une électrode de garde disposée en regard de plusieurs, en particulier de toutes les, électrodes de mesure ;
- pour au moins une, en particulier chaque, électrode de mesure, une électrode de garde disposée en regard de ladite électrode de mesure ;
- pour au moins une, en particulier chaque, électrode de mesure, plusieurs électrodes de garde disposées en regard de ladite électrode de mesure.

Suivant des modes de réalisation, le dispositif selon l'invention peut comprendre en outre au moins une seconde électrode de garde polarisée à un potentiel identique au potentiel de la ou des électrodes de mesure.

Le dispositif peut comprendre notamment une ou des secondes électrodes de garde disposées, par exemple :

- dans un même plan que des électrodes de mesure (par exemple pour protéger des pistes de liaison) ;
- dans un même plan que (et autour) des électrodes de gardes ;
- en regard des électrodes de garde, selon leur face opposée aux électrodes de mesure.

Suivant des modes de réalisation, le dispositif selon l'invention peut comprendre :

- une matrice d'électrodes de mesure ;
- des électrodes de garde individuelles disposées en regard des électrodes de mesure, et électriquement reliées entre elles ;
- une seconde électrode de garde disposée autour des électrodes de garde, dans un même plan.

Suivant des modes de réalisation, le dispositif selon l'invention peut comprendre plusieurs électrodes de mesure, et un commutateur d'électrodes permettant de relier sélectivement une électrode de mesure, dite « électrode active », à l'électronique de mesure, ledit commutateur d'électrodes étant en outre agencé pour polariser les autres électrodes de mesures au même potentiel électrique que l'électrode active.

Le commutateur d'électrodes peut permettre en particulier de sélectionner séquentiellement une pluralité de, ou toutes les, électrodes de mesure comme électrode active.

Il permet ainsi d'utiliser une électronique de mesure (ou une voie de mesure) pour effectuer une mesure séquentiellement avec plusieurs électrodes de mesures.

Ainsi, un dispositif selon l'invention avec une pluralité d'électrodes de mesure peut comprendre :

- Une électronique de mesure avec une seule voie de mesure et un commutateur d'électrodes permettant d'interroger séquentiellement toutes les électrodes de mesure (mesures séquentielles) ;
- Une ou plusieurs électroniques de mesure implémentant plusieurs voies de mesure avec chacune un commutateur d'électrodes permettant d'interroger une partie des électrodes de mesure (mesures séquentielles et parallèles ;
- Autant d'électroniques de mesure ou de voies de mesure que d'électrodes de mesures, sans commutateur d'électrodes, pour interroger simultanément toutes les électrodes de mesure (mesures parallèles).

Suivant des modes de réalisation, le dispositif selon l'invention, dans une configuration avec une deuxième source électrique agencée de sorte à appliquer la différence de potentiel électrique alternative à une pluralité d'électrodes de garde, peut comprendre en outre un commutateur d'électrodes de garde permettant de relier sélectivement une ou une pluralité d'électrodes de garde, dite « électrode(s) de garde excitée(s) », à la deuxième source, ledit commutateur d'électrode étant en outre agencé pour polariser les autres électrodes de garde au même potentiel électrique que l'électrode active.

Ce mode de réalisation présente l'avantage de permettre d'améliorer la résolution spatiale lors de la mesure du deuxième signal (la pression) par rapport à la résolution spatiale obtenue avec les électrodes de mesure, en particulier lorsque le dispositif selon l'invention comprend plusieurs électrodes de garde disposées en regard d'une électrode de mesure. Un effet, dans ce cas, si l'électrode de mesure est déformable, la résolution spatiale de la mesure est déterminée par la dimension de la ou des électrodes de garde excitées.

Suivant des modes de réalisation, l'électronique de mesure peut comprendre un circuit implémentant un amplificateur opérationnel avec une impédance comprenant une composante capacitive en contre réaction, la ou les électrodes de mesure étant reliées à l'entrée négative dudit amplificateur opérationnel.

L'électronique de mesure peut ainsi par exemple implémenter un amplificateur de charge avec une capacité en contre-réaction.

Le circuit implémentant un amplificateur opérationnel peut être réalisé sous toute forme, notamment analogique ou numérique, permettant de réaliser une fonction d'amplificateur opérationnel.

On rappelle qu'un amplificateur opérationnel est un modèle de composant bien connu de l'homme du métier avec une entrée positive et une entrée négative d'impédances idéalement infinies, et qui génère en sortie un signal correspondant à la différence des potentiels appliqués sur les entrées amplifiée avec un gain idéalement infini.

Le dispositif selon l'invention peut également comprendre une électronique de mesure avec un circuit implémentant un circuit de conversion de charges en signal électrique ou numérique (capacité commutée...).

Suivant des modes de réalisation, le circuit implémentant un amplificateur opérationnel peut être alimenté par une alimentation électrique référencée au premier potentiel électrique alternatif.

Suivant d'autres modes de réalisation, le circuit implémentant un amplificateur opérationnel peut être alimenté par une alimentation électrique référencée à la masse.

Suivant un autre aspect de la même invention, il est proposé un procédé de détection d'un objet par rapport à une surface de détection, mettant en œuvre un dispositif de détection selon la revendication 20.

La détection d'approche et/ou de contact peut comprendre par exemple une mesure de distance, une détection d'approche, une mesure ou une détection de contact.

La détection d'appui peut comprendre, par exemple, une détection d'appui, une mesure de force, une mesure de pression.

Le procédé selon l'invention peut en outre comprendre, en termes d'étapes ou d'opération, les fonctions mises en œuvre par le dispositif selon l'invention, suivant les caractéristiques décrites plus haut, dans chacun des modes/exemples de réalisation.

Suivant les modes de mise en œuvre et tel que décrit précédemment, la première étape et la deuxième étape peuvent être réalisées de manière simultanée ou séquentielle.

Suivant des modes de mise en œuvre lorsque le dispositif de détection comprend une pluralité d'électrodes de mesures, la deuxième étape de détection peut être réalisée (séquentiellement ou en parallèle) uniquement dans une zone de la surface de détection dans laquelle l'objet a été détecté (par exemple à proximité de ou en contact avec, la surface de détection) lors de la première étape de détection.

Ainsi, il n'est pas nécessaire de scruter toute la surface de détection lors de la deuxième étape de détection, ou d'appliquer cette deuxième étape de détection à toute la surface de détection.

Suivant des modes de mise en œuvre, le procédé selon l'invention peut comprendre une étape de calibrage comprenant :

- une détection d'approche et/ou de contact ;
- en l'absence d'objet détecté, une détection d'appui de sorte à déterminer une capacité électrode-garde dite « de calibrage ».

La condition d'absence d'objet détecté peut être réalisée en fonction d'un critère qui peut être, par exemple :

- la capacité électrode-objet mesurée est nulle ou au niveau du bruit de mesure, ce qui correspond à une absence totale de détection ;
- la capacité électrode-objet mesurée est inférieure à un seuil prédéterminé pour lequel on est sûr qu'il n'y a pas d'objet en contact avec la surface de détection (ce qui est suffisant pour qu'il n'y a pas de pression exercée), même si il y a un objet dans un voisinage de cette surface de détection.

La capacité électrode-garde de calibrage, qui correspond à une condition d'absence de pression ou d'appui, et donc à une distance nominale entre les électrodes de mesure et de garde, peut ensuite être utilisée pour calibrer les mesures d'appui ou de pression. Elle permet de compenser notamment des variations de distances en l'absence d'appui qui peuvent apparaître au cours du temps du fait de l'écrasement ou des variations de propriétés des matériaux entre les électrodes.

Suivant des modes de mise en œuvre lorsque le dispositif de détection comprend une pluralité d'électrodes de mesures, l'étape de calibrage peut être réalisée localement, dans au moins une zone de la surface de détection (ou par zones de la surface de détection).

Suivant des modes de mise en œuvre, le procédé selon l'invention peut comprendre une étape de vérification fonctionnelle comprenant une comparaison d'une capacité électrode-garde de calibrage avec une capacité électrode-garde nominale ou une gamme de capacité électrode-garde nominales.

La capacité électrode-garde nominale ou la gamme de capacité électrode-garde nominales correspondent à des valeurs de capacités attendues, préalablement déterminées, et correspondant à un fonctionnement correct du dispositif.

Cette étape de vérification permet de vérifier à tout instant le bon fonctionnement du dispositif, ce qui est essentiel pour des applications liées à la sécurité. En effet, si la capacité électrode-garde de calibrage mesurée ne se trouve pas dans une gamme de valeurs attendues cela signifie que le dispositif est défaillant et donc qu'il risque de ne pas détecter des objets à proximité ou en contact. On peut ainsi notamment déclencher une alarme de manière très fiable.

L'objet détecté peut être par exemple une main, portant ou non un gant, toute autre partie de corps humain, un stylet, par exemple réalisé en plastique ou en métal.

L'objet détecté peut être également tout objet de l'environnement du dispositif de détection, tel qu'un outil, une paroi ....

Suivant encore un autre aspect de l'invention, il est proposé une couche de détection pour un équipement comprenant un dispositif de détection selon l'invention.

Le dispositif selon l'invention, en particulier les électrodes, peu(ven)t être intégré(es) dans la couche de détection.

L'équipement peut notamment comprendre un appareil ou un appareil électronique, tel que par exemple une pièce de robot ou un robot.

La couche de détection peut être disposée sur, ou intégrée dans, une surface ou une coque de l'appareil.

La couche de détection peut alternativement se présenter sous la forme d'un élément d'habillage, tel qu'un textile d'habillage, indépendant dudit appareil.

La couche de détection peut aussi se présenter sous la forme d'une peau (ou « peau sensitive ») permettant de recouvrir tout ou partie d'un robot par exemple de forme humanoïde. Cette peau peut être conçue de sorte à avoir un aspect (couleur, surface, touché...) proche de celle d'une peau humaine.

La couche de détection peut aussi se présenter sous la forme d'une pièce ou d'un élément d'habillage de forme tubulaire, apte à être disposée par exemple autour d'un membre ou d'une portion de membre d'un robot.

L'équipement peut également comprendre un équipement médical ou médicalisé, tel qu'un lit, un matelas, un siège ou un coussin de siège.

Dans ce cas, la couche de détection peut notamment être réalisée sous la forme d'un élément d'habillage tel qu'un drap ou une housse, ou faire partie intégrante de l'équipement.

Dans ce cas, le dispositif selon l'invention peut être utilisé, de manière non limitative, pour détecter la présence d'un corps ou une personne, sa position, la pression exercée (par exemple pour prévenir des escarres), ses mouvements, des paramètres physiologiques (respiration, battements cardiaques), la présence d'humidité (urine), ...

Suivant encore un autre aspect de l'invention, il est proposé un équipement équipé d'un dispositif de détection selon l'invention.

L'équipement peut notamment comprendre un appareil ou un appareil électronique, tel que par exemple une pièce de robot ou un robot.

L'équipement peut également comprendre un équipement médical ou médicalisé, tel qu'un lit, un matelas, un siège ou un coussin de siège.

Le dispositif de détection peut être notamment agencé de sorte que des électrodes de mesure et de garde soient disposées sur au moins une partie de la périphérie de l'équipement.

Suivant des modes de réalisation dudit équipement :

- la ou les électrodes de mesure et de garde peuvent être disposées sur, ou dans, ou sous, une surface ou une coque dudit équipement ;
- la ou les électrodes de mesure et de garde peuvent être disposées dans un élément d'habillage indépendant dudit équipement , et rapporté sur ledit équipement ;
- la ou les électrodes de garde peuvent être disposées sur, ou dans, ou sous, une surface ou une coque dudit équipement ; et la ou les électrodes de mesure peuvent être disposées dans un élément d'habillage indépendant dudit équipement , et rapporté sur ledit équipement .

## Description des figures et modes de réalisation

D'autres avantages et caractéristiques apparaîtront à l'examen de la description détaillée d'exemples nullement limitatifs, et des dessins annexés sur lesquels :

- la FIGURE 1 est une représentation schématique du principe électrique d'un premier exemple de réalisation non limitatif d'un dispositif selon l'invention ;
- la FIGURE 2 est une représentation schématique du principe électrique d'un deuxième exemple de réalisation non limitatif d'un dispositif selon l'invention ;
- la FIGURE 3 est une représentation schématique du principe électrique d'un troisième exemple de réalisation non limitatif d'un dispositif selon l'invention ;
- la FIGURE 4 est une représentation schématique du principe électrique d'un quatrième exemple de réalisation non limitatif d'un dispositif selon l'invention ;
- la FIGURE 5 est une représentation schématique du principe électrique d'un cinquième exemple de réalisation non limitatif d'un dispositif selon l'invention ;
- les FIGURES 6-8 sont des représentations schématiques de différentes configurations d'électrodes pouvant être mises en œuvre dans un dispositif selon l'invention ;
- la FIGURE 9 est une représentation schématique d'un exemple de réalisation non limitatif d'un dispositif selon l'invention avec une pluralité d'électrodes de mesure.
- la FIGURE 10 est une représentation schématique d'un exemple de réalisation non limitatif d'un dispositif selon l'invention avec une pluralité d'électrodes de garde contrôlées individuellement.

Sur les figures, les éléments communs à plusieurs figures conservent la même référence.

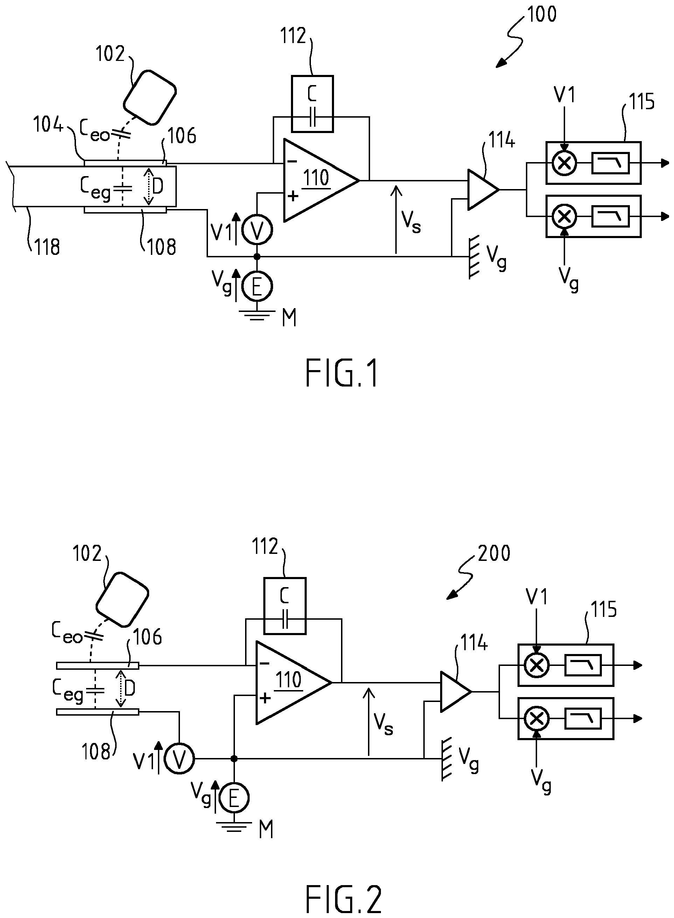

La FIGURE 1 est une représentation schématique du principe électrique d'un premier exemple de réalisation non limitatif d'un dispositif de détection selon l'invention.

Le dispositif 100, représenté de manière schématique sur la FIGURE 1, est prévu pour détecter l'approche, le contact et l'appui exercé par un objet de commande 102 sur une surface de détection 104.

Pour ce faire, le dispositif 100 comprend au moins une électrode 106, dite de mesure, disposée au niveau ou en regard de la surface de détection 104, et une électrode 108, dite de garde, disposée en regard de l'électrode de mesure 106 selon sa face opposée à la surface de détection 104, et à distance de cette électrode de mesure 106.

Dans les modes de réalisation présentés, la surface de détection 104 est matérialisée par une face de la ou des électrodes de mesure 106, de préférence recouverte d'une couche mince de matériau isolant à l'électricité (polyimide, vernis isolant, ...) pour éviter les court-circuit avec l'objet de commande 102.

Le dispositif 100 comprend en outre un circuit électronique qui peut être représenté sous la forme d'un amplificateur opérationnel (AO) 110, dont la sortie est bouclée sur son entrée négative par une impédance 112, qui peut être par exemple : un condensateur, un condensateur associé à une résistance, ou un condensateur associé à un commutateur de remise à zéro ou de décharge. Dans l'exemple représenté, l'impédance 112 est formée par une capacité C.

Le dispositif 100 comprend en outre une première source électrique E qui fournit un premier potentiel alternatif $V_g$. La première source électrique E est également appelée source électrique de garde, et le premier potentiel alternatif $V_g$ est également appelé potentiel de garde $V_g$, pour des raisons qui seront expliquées plus loin. Ce premier potentiel alternatif $V_g$, ou potentiel de garde $V_g$, est différent d'un potentiel de masse électrique, notée M, correspondant au potentiel de la masse générale du système (qui peut être par exemple la terre). La première source électrique E est reliée en entrée au potentiel de masse M et en sortie notamment à l'électrode de garde 108.

Il est à noter que l'objet de commande 102, par principe, est normalement polarisé au potentiel de masse M, directement ou indirectement par couplage résistif ou capacitif. Bien entendu rien n'oblige à ce que l'objet soit parfaitement polarisé à ce potentiel de masse M. Pour qu'il puisse être détecté, il faut simplement qu'il soit polarisé à un potentiel différent du potentiel de garde $V_g$.

Dans les modes de réalisation présentés, l'amplificateur opérationnel (AO) 110 est référencé au potentiel de garde $V_g$. Pour cela, il est alimenté par une source d'alimentation électrique (non représentée) également référencée au potentiel de garde $V_g$.

Alternativement, l'amplificateur opérationnel (AO) 110 peut être référencé au potentiel de masse, en étant alimenté par une source d'alimentation électrique (non représentée) référencée au potentiel de masse électrique M.

La tension électrique $V_s$ présente sur la sortie de l'AO 110 est référencée au potentiel de garde $V_g$.

Pour obtenir une tension $V_s$ référencée au potentiel de masse général M, le dispositif comprend un module 114 représenté sous la forme d'un amplificateur différentiel 114 électriquement référencé au potentiel de masse général M, et relié en entrée respectivement à la sortie de l'AO 110 et au potentiel de garde. Ainsi on obtient en sortie de cet amplificateur différentiel 114 un signal image de $V_s$ référencé au potentiel de masse général M.

Dans l'exemple représenté, le dispositif 100 comprend en outre une deuxième source électrique V, disposée entre l'entrée positive de l'AO 110 et la source de garde E, et fournissant une différence de potentiel électrique alternative V1.

Dans ce mode de réalisation, l'électrode de mesure 106 est reliée à l'entrée négative de l'AO 110 et l'électrode de garde 108 est reliée en un point entre la source de garde E et la deuxième source V.

Du fait de l'impédance et du gain en boucle ouverte très élevés de l'AO 110, on peut considérer que l'électrode de mesure 106 reliée à l'entrée négative de l'AO 110 est polarisée (relativement au potentiel de masse M) à un potentiel électrique correspondant à la somme du potentiel de garde $V_g$ (ou du premier potentiel électrique alternatif $V_g$) et de la différence de potentiel électrique alternative V1.

L'électrode de garde est polarisée au potentiel de garde ou premier potentiel électrique alternatif $V_g$.

L'électrode de mesure 106 est agencée de sorte que la distance D entre l'électrode de mesure 106 et l'électrode de garde 108 peut être modifiée, de manière élastique, localement, par une pression exercée par l'objet de commande 102 sur la surface de détection 104. En particulier, lorsqu'une pression est appliquée sur la surface de détection 104, l'électrode de mesure 106 se rapproche de l'électrode de garde 108. A cet effet, les électrodes de mesure 106 et de garde 108 sont disposées de part et d'autre (ou dans) une couche 118, formée par un matériau diélectrique élastiquement compressible, tel que par exemple de la mousse ou du plastique ou encore un diélectrique liquide.

Dans ces conditions, l'approche et le contact de l'objet de commande 102 avec la surface de détection 104 peuvent être détectés et/ou mesurés par mesure d'une valeur représentative d'une capacité $C_{eo}$, dite capacité électrode-objet, formée entre l'électrode de mesure 106 et l'objet de commande 102. Une fois au contact de la surface de détection 104, la pression exercée par l'objet de commande 102 peut être détectée et/ou mesurée par mesure d'une valeur d'une capacité $C_{eg}$, dite capacité électrode-garde, formée entre l'électrode de mesure 106 et l'électrode de garde 108.

Dans les deux cas, on peut relier les capacités mesurées, en utilisant la loi du condensateur plan, respectivement à une distance entre l'électrode de mesure et l'objet, et à une distance entre l'électrode de mesure et l'électrode de garde. La pression peut alors être calculée à partie de la variation d'épaisseur mesurée du matériau diélectrique 118.

Le signal $V_s$ mesuré en sortie de l'AO 110 comprend une combinaison d'un premier signal $V_{sa}$ et d'un deuxième signal $V_{sp}$ qui sont respectivement dépendant de la capacité électrode-objet $C_{eo}$, et d'une somme des capacités électrode-objet et électrode-garde $C_{eg}$:

$$V_s = V_{sa} + V_{sp} \ (1)$$

avec

$$V_{sa} = V_g \frac{C_{eo}}{C} \ (2)$$

et

$$V_{sp} = V1.(1 + \frac{C_{eo}+C_{eg}}{C}) \ (3)$$

Suivant un mode de mise en œuvre, on génère un premier potentiel électrique $V_g$ et une différence de potentiel V1 avec des fréquences fondamentales différentes et suffisamment éloignées pour pouvoir être séparées par démodulation et/ou par filtrage. Ces signaux peuvent être par exemple sinusoïdaux ou carrés. Dans ce cas, les premiers et seconds signaux $V_{sa}$ et $V_{sp}$ obtenus ont également des fréquences fondamentales différentes. Il est alors possible d'obtenir l'amplitude respective de ces premiers et seconds signaux $V_{sa}$ et $V_{sp}$ en démodulant le signal $V_s$ autour, respectivement, de la fréquence fondamentale du premier potentiel électrique $V_g$ pour le premier signal $V_{sa}$, et de la fréquence fondamentale de la différence de potentiel V1 pour le second signal $V_{sp}$. On peut alors déduire de l'amplitude de ces signaux, respectivement, la capacité électrode-objet $C_{eo}$ et la somme des capacités électrode-objet et électrode-garde $C_{eo} + C_{eg}$, donc la capacité électrode-garde $C_{eg}$. On obtient donc ainsi simultanément un premier signal relatif à la valeur de la capacité électrode-objet $C_{eo}$, et un deuxième signal relatif à la valeur de la capacité électrode-garde $C_{eg}$.

A cet effet, le dispositif 100 comprend deux démodulateurs synchrones 115 qui réalisent des fonctions de multiplication du signal $V_s$ issu de l'AO 110 avec, respectivement, un signal de porteuse correspondant au premier potentiel électrique $V_g$ et un signal de porteuse correspondant à la différence de potentiel V1, puis de filtrage passe-bas.

Ces démodulations de premiers et seconds signaux $V_{sa}$ et $V_{sp}$ à des fréquences différentes peuvent également être réalisées avec un démodulateur asynchrone comprenant un redressement suivi d'un filtre passe-bas.

De préférence le signal $V_s$ est filtré passe bande autour, respectivement, des fréquences fondamentales des premiers et seconds signaux $V_{sa}$ et $V_{sp}$ avant la démodulation.

Suivant d'autres modes de mise en œuvre, on peut générer un premier potentiel électrique $V_g$ et une différence de potentiel V1 sous la forme de signaux orthogonaux entre eux (c'est-à-dire dont le produit scalaire est nul). On peut générer de tels signaux par exemple sous la forme de signaux en quadrature de phase (par exemple sinusoïdaux ou carrés), ou sous la forme de séquences binaires constituant une base de signaux orthogonaux.

Dans ce cas, on peut démoduler les premiers et seconds signaux $V_{sa}$ et $V_{sp}$ comme précédemment avec des démodulateurs synchrones 115, en utilisant respectivement un signal de porteuse correspondant au premier potentiel électrique $V_g$ et un signal de porteuse correspondant à la différence de potentiel V1, puis de filtrage passe-bas. De manière plus générale, si on démodule le premier signal $V_{sa}$ avec un signal de porteuse orthogonal au deuxième signal $V_{sp}$ et réciproquement, on peut obtenir leurs amplitudes respectives sans diaphonie.

Bien entendu, ces opérations de démodulation peuvent être réalisées de manière analogique, avec des composants d'électronique analogique, et/ou de manière numérique, avec un FPGA, un microprocesseur, .... Elles peuvent être par exemple réalisées en numérisant les signaux analogiques (par exemple le signal $V_s$) puis en effectuant les opérations de démodulation par calcul avec FPGA ou un microprocesseur.

Il est également possible de mettre en œuvre le dispositif 100 avec la source de garde E et la deuxième source V allumée alternativement (et donc une seule à la fois). Dans ce cas, on mesure alternativement en sortie de l'AO un signal $V_s$ qui correspond respectivement au premier signal $V_{sa}$ ou au deuxième signal $V_{sp}$, selon la source qui est allumée. On peut alors démoduler ce signal $V_s$ comme précédemment avec deux démodulateurs 115, ou n'utiliser qu'un seul démodulateur en commutant le signal de porteuse pour qu'il corresponde à celui de la source allumée.

Il est à noter qu'une source de tension, telle que la première source électrique E ou la deuxième source électrique V, se comporte comme un court-circuit lorsqu' elle est éteinte.

Dans ce mode de mise en œuvre, il est également possible de mettre en œuvre une source électrique de garde E et une deuxième source V qui utilisent la même fréquence d'excitation ou qui génèrent un signal de même forme, ce qui simplifie l'électronique de détection.

Il est également possible de maintenir la source de garde E allumée en permanence mais de n'allumer la deuxième source V que périodiquement, ou uniquement lorsqu'un objet 102 est détecté en contact ou à proximité de la surface de détection 104, à partir de la mesure de capacité électrode-objet $C_{eo}$. Cela permet de mesurer la capacité électrode-objet $C_{eo}$ dans de meilleures conditions, de manière plus précise et en limitant les risques de diaphonie, en particulier lorsque les objets 102 sont éloignés et donc que cette capacité électrode-objet $C_{eo}$ est très faible. Lorsque les objets 102 sont à proximité ou en contact avec la surface de détection 104, on mesure simultanément (ou séquentiellement) les capacités électrode-objet $C_{eo}$ et électrode-garde $C_{eg}$ comme décrit précédemment.

Il est à noter que les électrodes de garde 108 remplissent les fonctions suivantes :

- Pour la mesure de la capacité électrode-objet $C_{eo}$, les électrodes de garde 108 protègent les électrodes de mesure 106 des couplages capacitifs parasites avec l'environnement en étant polarisées au même potentiel que les électrodes de mesure 106, au moins du point de vue de la démodulation par rapport au premier potentiel électrique alternatif. Il est à noter que cela est vrai même quand la deuxième source V est allumée, dans la mesure où elle fournit une différence de potentiel alternative V1 orthogonale au premier potentiel électrique alternatif, ou avec des fréquences différentes. Dans ce sens, le premier potentiel électrique alternatif est un potentiel de garde ;
- Pour la mesure de la capacité électrode-garde $C_{eg}$, les électrodes de garde 108 sont à un potentiel différent des électrodes de mesure 106, avec une différence correspondant à la différence de potentiel alternative V1. Cela permet l'apparition d'une capacité $C_{eg}$ mesurable avec une démodulation basée sur la différence de potentiel alternative V1.

La FIGURE 2 est une représentation schématique allégée du principe électrique d'un deuxième exemple de réalisation d'un dispositif selon l'invention.

Le dispositif 200, représenté sur la FIGURE 2, comprend tous les éléments du dispositif 100 de la FIGURE 1.

Dans le dispositif 200, à la différence du dispositif 100, la deuxième source électrique V est reliée à l'électrode de garde 108, et non pas à l'électrode de mesure 106 par l'intermédiaire des entrées de l'AO 110 comme illustré à la FIGURE 1. L'entrée positive de l'AO 110 est reliée au potentiel de garde $V_g$. La deuxième source électrique V est également référencée au potentiel de garde $V_g$.

Le fonctionnement du dispositif 200 est pour l' essentiel similaire à celui du dispositif 100.

Lorsque la première source électrique E et la deuxième source électrique V sont allumées et génèrent respectivement le potentiel de garde (ou premier potentiel électrique alternatif) $V_g$ et de la différence de potentiel électrique alternative V1, on mesure en sortie de l'amplificateur opérationnel (AO) 110 un signal $V_s$ correspondant à la somme de deux signaux $V_{sa}$ et $V_{sp}$ représentatifs respectivement de la capacité électrode-objet $C_{eo}$ et la capacité électrode-garde $C_{eg}$ :

$$V_s = V_{sa} + V_{sp} \quad (4)$$

avec

$$V_{sa} = V_g \frac{C_{eo}}{C} \quad (5)$$

et

$$V_{sp} = -V1 \frac{C_{eg}}{C} \quad (6)$$

Il est à noter que dans ce mode de réalisation du dispositif 200, le signal $V_{sp}$ représentatif de la capacité électrode-garde $C_{eg}$ ne dépend pas de la capacité électrode-objet $C_{eo}$, comme dans le cas du dispositif 100. C'est un avantage de ce mode de réalisation.

Le signal $V_s$ peut être démodulé comme expliqué en relation avec le dispositif 100, avec un ou deux démodulateurs 115. En particulier, toutes les méthodes de démodulation expliquées en relation avec le dispositif 100 sont applicable au dispositif 200.

Comme expliqué précédemment, le dispositif 200 peut donc être mis en œuvre avec la première source électrique E et la deuxième source électrique V allumées ou actives simultanément, pour autant que le premier potentiel électrique alternatif $V_g$ et de la différence de potentiel électrique alternative V1 générés soient des signaux orthogonaux ou de fréquences différentes. On peut alors démoduler en parallèle les signaux $V_{sa}$ et $V_{sp}$ avec deux démodulateurs 115 comme expliqué précédemment. Dans ce cas on obtient simultanément le premier signal relatif à la valeur de la capacité électrode-objet $C_{eo}$ et le deuxième signal relatif à la valeur de la capacité électrode-garde $C_{eg}$.

Le dispositif 200 peut également être mis en œuvre en allumant alternativement uniquement la première source électrique E, puis la deuxième source électrique V. Dans ce cas, le premier potentiel électrique alternatif $V_g$ et de la différence de potentiel électrique alternative V1 générés peuvent être comme précédemment des signaux orthogonaux ou de fréquence différente, mais ils peuvent être également de même fréquence ou de même forme. On mesure alors alternativement ou séquentiellement deux signaux représentatifs respectivement de la capacité électrode-objet $C_{eo}$ et la capacité électrode-garde $C_{eg}$.

Comme décrit en relation avec le dispositif 100, il est également possible de maintenir la première source électrique E allumée en permanence mais de n'allumer la deuxième source électrique V que périodiquement, ou uniquement lorsqu'un objet 102 est détecté en contact ou à proximité de la surface de détection 104, à partir de la mesure de capacité électrode-objet $C_{eo}$. Cela permet de mesurer la capacité électrode-objet $C_{eo}$ dans de meilleures conditions, de manière plus précise et en limitant les risques de diaphonie, en particulier lorsque les objets 102 sont éloignés et donc que cette capacité électrode-objet $C_{eo}$ est très faible. Lorsque les objets 102 sont à proximité ou en contact avec la surface de détection 104, on mesure simultanément (ou séquentiellement) les capacités électrode-objet $C_{eo}$ et électrode-garde $C_{eg}$ comme décrit précédemment.

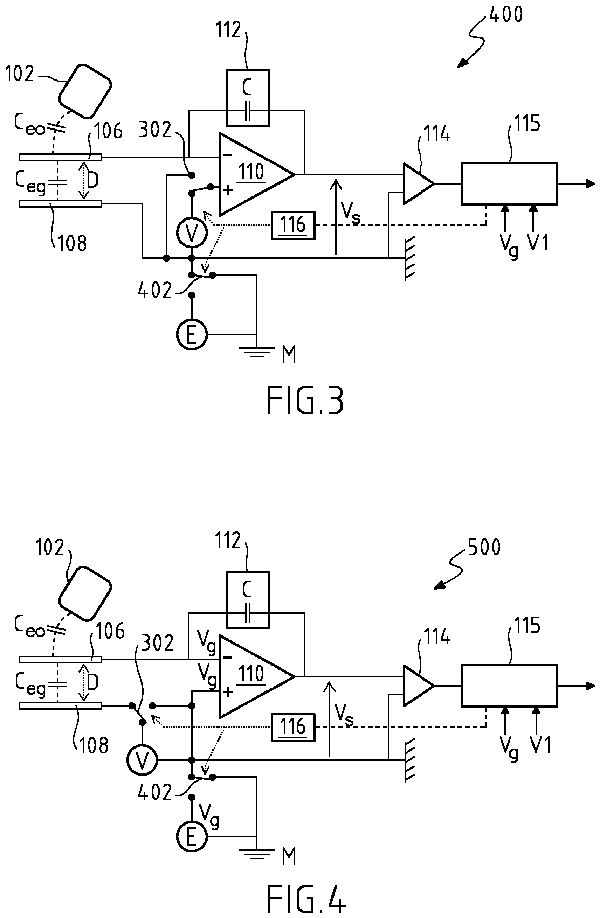

La FIGURE 3 est une représentation schématique allégée du principe électrique d'un troisième exemple de réalisation d'un dispositif selon l'invention.

Le dispositif 400, représenté sur la FIGURE 3, comprend tous les éléments du dispositif 100 de la FIGURE 1. Il comprend notamment une première source électrique E reliée en entrée au potentiel de masse M et en sortie notamment à l'électrode de garde 108. Il comprend également une deuxième source électrique V, disposée entre, d'une part, l'électrode de garde 108 et la sortie de la première source électrique E, et d'autre part, l'entrée positive de l'AO 110.

Le dispositif 400 comprend en outre un premier commutateur 402 disposé en sortie de la première source électrique E. Ce premier commutateur 402 est commandé par le module de commande 116 et permet de relier l'électrode de garde 108 :

- dans une première position, à la sortie de la première source électrique E ; et
- dans une deuxième position, au potentiel de masse M.

Le dispositif 400 comprend également un second commutateur 302 disposé en sortie de la deuxième source électrique V. Ce second commutateur 302 est également commandé par le module de commande 116 et permet de relier l'entrée positive de l'AO 110 :

- dans une première position, à l'électrode de garde 108 ; et
- dans une deuxième position, à la sortie de la deuxième source électrique V.

Il est à noter que le dispositif 400 est fonctionnellement équivalent au dispositif 100 dans le cas où on allume et on éteint, respectivement, la première source électrique E ou la deuxième source électrique V.

Le premier commutateur 402 est disposé de sorte à connecter ou déconnecter la première source électrique E, ou plus précisément la sortie de cette première source électrique E, du reste du circuit, en faisant en sorte, lorsque la première source électrique E est déconnectée, de relier l'électrode de garde 108 au potentiel de masse M (comme si la première source électrique E était éteinte). Il permet ainsi d'éviter d'allumer et d'éteindre cette première source électrique E à haute cadence.

De même, le second commutateur 302 est disposé de sorte à connecter ou déconnecter la seconde source électrique V, ou plus précisément la sortie de cette seconde source électrique V, du reste du circuit, en faisant en sorte, lorsque la seconde source électrique V est déconnectée, de relier l'entrée de l'AO 110 à l'électrode de garde 108 (comme si la seconde source électrique V était éteinte). Il permet ainsi d'éviter d'allumer et d'éteindre cette seconde source électrique V à haute cadence.

Tous les modes de mise en œuvre décrits en relation avec dispositif 100 de la FIGURE 1 sont applicables au dispositif 400.

Toutefois, bien entendu, le dispositif 400 est particulièrement bien adapté à la réalisation de mesures séquentielles, avec la première source électrique E et la deuxième source V activées alternativement (et donc une seule à la fois). Dans ce cas, on mesure alternativement en sortie de l'AO un signal $V_s$ qui correspond respectivement au premier signal $V_{sa}$ ou au deuxième signal $V_{sp}$, selon la source qui est activée. On peut alors démoduler ce signal $V_s$ comme précédemment avec deux démodulateurs 115, ou n'utiliser qu'un seul démodulateur 115 tel qu'illustré à la FIGURE 3 en commutant le signal de porteuse (par exemple avec le module de commande 116) pour qu'il corresponde à celui de la source activée.

Ainsi, pour la mesure du premier signal $V_{sa}$, le premier commutateur 402 est commuté pour relier l'électrode de garde 108 à la sortie de la première source électrique E, et le second commutateur 302 est commuté pour relier l'entrée positive de l'AO 110 à la sortie de la première source électrique E (ou à l'électrode de garde 108). Pour la mesure du deuxième signal $V_{sp}$, le premier commutateur 402 est commuté pour relier l'électrode de garde 108 au potentiel de masse M, et le second commutateur 302 est commuté pour relier l'entrée positive de l'AO 110 à la sortie de la deuxième source électrique V.

Suivant une variante, le dispositif 400 peut comprendre un premier commutateur 402 et pas de second commutateur 302. Dans ce cas, la seconde source V est toujours insérée dans le circuit. Bien entendu, elle peut être allumée ou éteinte tel que décrit précédemment.

Suivant une variante, le dispositif 400 peut comprendre un second commutateur 302 et pas de premier commutateur 402. Dans ce cas, la première source E est toujours insérée dans le circuit. Bien entendu, elle peut être allumée ou éteinte tel que décrit précédemment.

La FIGURE 4 est une représentation schématique allégée du principe électrique d'un quatrième exemple de réalisation d'un dispositif selon l'invention.

Le dispositif 500, représenté sur la FIGURE 4, comprend tous les éléments du dispositif 200 de la FIGURE 2. Il comprend notamment une première source électrique E reliée en entrée au potentiel de masse M et en sortie à l'entrée positive de l'AO 110. Il comprend également une deuxième source électrique V, disposée entre, d'une part, la sortie de la première source électrique E, et d'autre part, l'électrode de garde 108.

Le dispositif 500 comprend en outre un premier commutateur 402 disposé en sortie de la première source électrique E. Ce premier commutateur 402 est commandé par le module de commande 116 et permet de relier l'entrée positive de l'AO 110 :

- dans une première position, à la sortie de la première source électrique E ; et
- dans une deuxième position, au potentiel de masse M.

Le dispositif 500 comprend également un second commutateur 302 disposé en sortie de la deuxième source électrique V. Ce second commutateur 302 est également commandé par le module de commande 116 et permet de relier l'électrode de garde 108 :

- dans une première position, à l'entrée positive de l'AO 110 ; et
- dans une deuxième position, à la sortie de la deuxième source électrique V.

Il est à noter que le dispositif 500 est fonctionnellement équivalent au dispositif 200 dans le cas où on allume et on éteint, respectivement, la première source électrique E ou la deuxième source électrique V.

Le premier commutateur 402 est disposé de sorte à connecter ou déconnecter la première source électrique E, ou plus précisément la sortie de cette première source électrique E, du reste du circuit, en faisant en sorte, lorsque la première source électrique E est déconnectée, de relier l'entrée positive de l'AO 110 au potentiel de masse M (comme si la première source électrique E était éteinte). Il permet ainsi d'éviter d'allumer et d'éteindre cette première source électrique E à haute cadence.

De même, le second commutateur 302 est disposé de sorte à connecter ou déconnecter la seconde source électrique V, ou plus précisément la sortie de cette seconde source électrique V, du reste du circuit, en faisant en sorte, lorsque la seconde source électrique V est déconnectée, de relier l'électrode de garde 108 à l'entrée positive de l'AO 110 (comme si la seconde source électrique V était éteinte). Il permet ainsi d'éviter d'allumer et d'éteindre cette seconde source électrique V à haute cadence.

Tous les modes de mise en œuvre décrits en relation avec dispositif 200 de la FIGURE 2 sont applicables au dispositif 500.

Toutefois, bien entendu, le dispositif 500 est particulièrement bien adapté à la réalisation de mesures séquentielles, avec la première source électrique E et la deuxième source V activées alternativement (et donc une seule à la fois). Dans ce cas, on mesure alternativement en sortie de l'AO un signal $V_s$ qui correspond respectivement au premier signal $V_{sa}$ ou au deuxième signal $V_{sp}$, selon la source qui est activée. On peut alors démoduler ce signal $V_s$ comme précédemment avec deux démodulateurs 115, ou n'utiliser qu'un seul démodulateur 115 tel qu'illustré à la FIGURE 4 en commutant le signal de porteuse (par exemple avec le module de commande 116) pour qu'il corresponde à celui de la source activée.

Ainsi, pour la mesure du premier signal $V_{sa}$, le premier commutateur 402 est commuté pour relier l'entrée positive de l'AO 110 à la sortie de la première source électrique E, et le second commutateur 302 est commuté pour relier l'électrode de garde 108 à la sortie de la première source électrique E (ou à l'entrée positive de l'AO 110). Pour la mesure du deuxième signal $V_{sp}$, le premier

commutateur 402 est commuté pour relier l'entrée positive de l'AO 110 au potentiel de masse M, et le second commutateur 302 est commuté pour relier l'électrode de garde 108 à la sortie de la deuxième source électrique V.

Suivant une variante, le dispositif 500 peut comprendre un premier commutateur 402 et pas de second commutateur 302. Dans ce cas, la seconde source V est toujours insérée dans le circuit. Bien entendu, elle peut être allumée ou éteinte tel que décrit précédemment.

Suivant une variante, le dispositif 500 peut comprendre un second commutateur 302 et pas de premier commutateur 402. Dans ce cas, la première source E est toujours insérée dans le circuit. Bien entendu, elle peut être allumée ou éteinte tel que décrit précédemment.

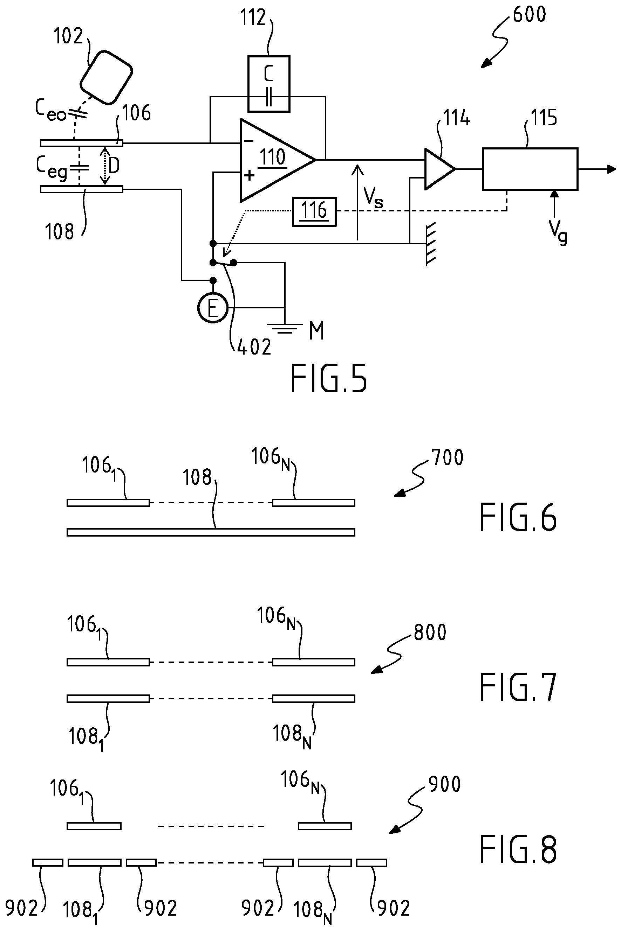

La FIGURE 5 est une représentation schématique allégée du principe électrique d'un cinquième exemple de réalisation d'un dispositif selon l'invention.

Le dispositif 600, représenté sur la FIGURE 5, comprend tous les éléments du dispositif 500 de la FIGURE 4 par exemple. Il en diffère toutefois en ce que :

- il ne comprend pas de deuxième source électrique V, ni de second commutateur 302 ;
- l'électrode de garde 108 est reliée à tout moment à la sortie de la première source électrique E et reçoit le potentiel $V_g$ fourni par cette première source électrique E.

Le dispositif 600 comprend un premier commutateur 402 disposé en sortie de la première source électrique E, et en aval de l'électrode de garde 108. Ce premier commutateur 402 est commandé par le module de commande 116, et permet de relier l'entrée positive de l'AO 110 :

- dans une première position, à la sortie de la première source électrique E et à l'électrode de garde 108 ; et
- dans une deuxième position, au potentiel de masse M.

Ce mode de réalisation est très simple dans la mesure où il ne comprend qu'une source, la première source électrique E. Il ne permet par contre que des mesures séquentielles du premier signal relatif à la valeur de $C_{eo}$ et du deuxième signal relatif à la valeur de $C_{eg}$.

Pour la mesure du premier signal relatif à la valeur de $C_{eo}$, le module de commande 116 commande le premier commutateur 402 pour relier l'entrée positive de l'AO 110 à la première source électrique E : dans cette position l'électrode de garde 108 et l'électrode de mesure 106 reçoivent le premier potentiel $V_g$.

Pour la mesure du deuxième signal relatif à la valeur de $C_{eg}$, le module de commande 116 commande le premier commutateur 402 pour relier l'entrée positive de l'AO 110 au potentiel de masse M : l'électrode de garde 108 est alors au premier potentiel $V_g$ et l'électrode de mesure 106 au potentiel de masse M. En d'autres termes, dans cette configuration, on applique entre l'électrode de mesure 106 et l'électrode de garde 108 une différence de potentiel électrique alternative V1 correspondant au premier potentiel $V_g$.

Dans ce mode de réalisation, la mesure du premier signal fournit en sortie de l'AO un signal :

$$V_{sa} = V_g \frac{C_{eo}}{C} \quad (7)$$

Et la mesure du second signal fournit en sortie de l'AO un signal :

$$V_{sp} = -V_g \frac{C_{eg}}{C} \quad (8)$$

On peut alors démoduler le premier signal $V_{sa}$ et le deuxième signal $V_{sp}$ avec un démodulateur 115, en utilisant le même signal de porteuse (pour un démodulateur synchrone).

Suivant une variante du dispositif 600 (non représentée), le commutateur 402 peut être disposé entre l'électrode de garde 108 d'une part, et la source E et le potentiel de masse d'autre part, en reliant l'entrée positive de l'AO 110 à la source E à tout moment.

Dans ce cas, le premier commutateur 402 permet de relier l'électrode de garde 108 :

- dans une première position, à la sortie de la première source électrique E et à l'entrée positive de l'AO 110 ; et
- dans une deuxième position, au potentiel de masse M.

Dans cette configuration, l'électrode de mesure 106 est toujours polarisée au premier potentiel $V_g$ par l'intermédiaire de l'entrée positive de l'AO 110.

Chacun des dispositifs décrits peut en outre comprendre au moins un module de calcul (non représenté sur les FIGURES) configuré pour :

- déterminer une distance, un contact ou un quasi-contact entre l'objet 102 et la surface de détection 104 en fonction du premier signal mesuré ; et/ou
- déterminer une pression appliquée par ledit objet 102 sur la surface de détection 104 en fonction du deuxième signal mesuré.

La FIGURE 6 est une représentation schématique d'une première configuration d'électrodes pouvant être mise en œuvre dans un dispositif selon l'invention.

Dans la configuration 700, représentée sur la FIGURE 6, le dispositif peut comprendre une pluralité d'électrodes de mesure $106_1$-$106_N$ et une unique électrode de garde 108, commune à toutes les électrodes de mesure $106_1$-$106_N$. Dans la configuration illustrée, cette électrode de garde 108 est disposée en regard de la face des électrodes de mesures $106_1$-$106_N$ opposée à la surface de détection 104.

La FIGURE 7 est une représentation schématique d'une deuxième configuration d'électrodes pouvant être mise en œuvre dans un dispositif selon l'invention.

Dans la configuration 800, représentée sur la FIGURE 7, le dispositif peut comprendre une pluralité d'électrodes de mesure $106_1$-$106_N$ et une électrode de garde individuelle, respectivement $108_1$-$108_N$, pour chaque électrode de mesure $106_1$-$106_N$. Dans la configuration illustrée, ces électrodes de garde $108_1$-$108_N$ sont disposées en regard de la face des électrodes de mesures $106_1$-$106_N$ opposée à la surface de détection 104.

La FIGURE 8 est une représentation schématique d'une troisième configuration d'électrodes pouvant être mise en œuvre dans un dispositif selon l'invention.

Dans la configuration 900, représentée sur la FIGURE 8, le dispositif comprend une pluralité d'électrodes de mesure $106_1$-$106_N$ et une électrode de garde individuelle, respectivement $108_1$-$108_N$, pour chaque électrode de mesure $106_1$-$106_N$.

Il comprend en outre des secondes électrodes de garde 902 disposées de préférence dans un même plan que les électrodes de garde $108_1$-$108_N$. Ces secondes électrodes de garde peuvent être réalisées sous la forme d'un plan de garde unique 902, ou sous la forme d'électrodes distinctes reliées à un même potentiel.

Ces secondes électrodes de garde 902 sont maintenues au potentiel des électrodes de mesure 106, ou du moins à un potentiel identique ou sensiblement identique au potentiel des électrodes de mesure 106. Elles permettent ainsi de réaliser une garde de ces électrodes de mesure 106, y compris pendant les mesures du deuxième signal relatif à la valeur de $C_{eg}$, en évitant l'apparition de capacités parasites entre ces électrodes 106 et leur environnement. Pour cela, dans les modes de réalisation décrits en relation avec les FIGURE 1 à FIGURE 5, les secondes électrodes de garde 902 sont électriquement reliées à l'entrée positive de l'AO 110. Ainsi, elles « suivent » le potentiel imposé aux entrées de l'AO 110 et aux électrodes de mesure 106 dans toutes les configurations de mesure.

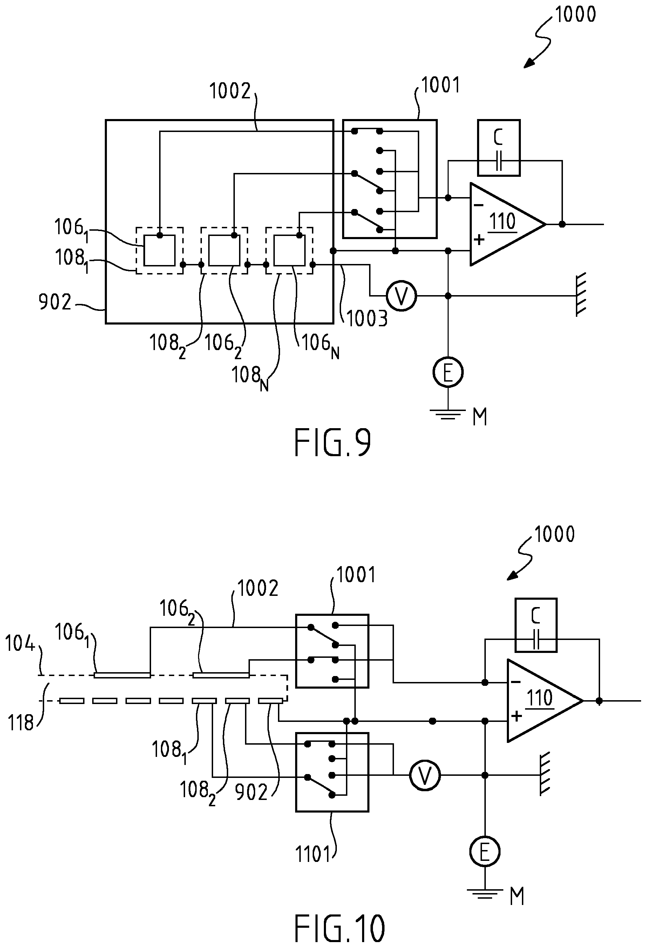

La FIGURE 9 est une représentation schématique d'un exemple de réalisation non limitatif d'un dispositif selon l'invention avec une pluralité d'électrodes de mesure.

Elle illustre un exemple de configuration 1000 permettant de réaliser des mesures avec une pluralité d'électrodes de mesures 106 de manière séquentielle. Cette configuration 1000 est décrite sur la base de la configuration 200 de la FIGURE 2, étant bien entendu qu'il peut être mis en œuvre avec tous les modes de réalisations décrits précédemment.

Le dispositif comprend une pluralité d'électrodes de mesure $106_1$-$106_N$ reliées respectivement à un commutateur électronique (switch) d'électrodes 1001 par des pistes de liaison 1002.

Le commutateur d'électrodes 1001 est relié en sortie à l'entrée de mesure (l'entrée négative) de l'AO 110. Il permet de sélectionner une électrode de mesure $106_1$-$106_N$ avec laquelle les mesures du premier et du deuxième signal sont effectuées comme décrit précédemment. Ce commutateur d'électrodes 1001 est en outre agencé de sorte que chaque électrode de mesure $106_1$-$106_N$ est reliée, soit à l'entrée de mesure de l'AO 110 pour constituer une électrode active (mesurante), soit à un potentiel identique ou sensiblement identique à celui appliqué à la ou les électrodes actives. De préférence, une seule électrode active est sélectionnée à la fois.

Dans tous les modes de réalisation présentés, les électrodes de mesures $106_1$-$106_N$ qui ne sont pas actives sont reliées par le commutateur d'électrodes 1001 à l'entrée positive de l'AO 110, qui est comme expliqué précédemment au même potentiel que l'électrode de mesure 106 active.

Le fait de polariser les électrodes de mesures $106_1$-$106_N$ qui ne sont pas actives à un potentiel identique ou sensiblement identique à celui appliqué à la ou les électrodes actives permet d'éviter toute diaphonie entre la ou les électrodes mesurantes sélectionnées et les électrodes non mesurantes. Les électrodes non mesurantes qui se trouvent ainsi au potentiel de la garde participent à l'optimisation de la portée de la ou des électrodes mesurantes pour la détection de proximité en créant un maximum de surface à la garde.

Le dispositif comprend également une pluralité d'électrodes de garde $108_1$-$108_N$ disposées respectivement en regard des électrodes de mesure $106_1$-$106_N$. Ces électrodes de garde $108_1$-$108_N$ sont interconnectées par une piste de liaison 1003 qui permet de les relier à l'électronique. Suivant le mode de réalisation considéré et comme décrit précédemment, les électrodes de gardes $108_1$-$108_N$ sont ainsi toutes reliées à la deuxième source électrique V comme illustré, ou :

- à la sortie de la première source électrique E (configuration 100, 600) ;
- au commutateur 302 (configurations 500) ;
- au commutateur 402 (configuration 400).

La surface, le taux de recouvrement et la forme de ces électrodes $108_1$-$108_N$ peut comprendre une grande variété de configurations, en fonction des applications : plus grandes, identiques ou plus petites que les électrodes de mesure $106_1$-$106_N$, agencées de sorte à recouvrir partiellement une ou plusieurs électrodes de mesure, sous forme de surfaces pleines ou ajourées ou de pistes ou de formes quelconques.

Alternativement, comme expliqué précédemment, les électrodes de garde $108_1$-$108_N$ peuvent être réalisées sous la forme d'un plan de garde, ou d'une électrode de garde unique 108.

De manière optionnelle, le dispositif comprend également une seconde électrode de garde 902 sous la forme d'un plan de garde 902 disposé entre les électrodes de garde $108_1$-$108_N$. Cette seconde électrode de garde est reliée, comme décrit précédemment, à l'entrée positive de l'AO 110 pour être maintenue au même potentiel que la ou les électrodes de mesure $106_1$-$106_N$ actives. Cette seconde électrode de garde 902 apporte par exemple un avantage significatif au niveau de la liaison entre la surface de détection 104 et l'électronique en éliminant les fuites capacitives de cette liaison (laquelle liaison peut être un câble, un prolongement de la surface active, une liaison flexible, un élément de circuit imprimé, ...).

La FIGURE 10 est une représentation schématique d'un exemple de réalisation non limitatif d'un dispositif selon l'invention avec une pluralité d'électrodes de mesure et une pluralité d'électrodes de garde.

Elle illustre un exemple de mode de réalisation 1100 qui permet de commander sélectivement les électrodes de gardes.

Ce mode de réalisation 1100 est similaire au mode de réalisation 1000, aussi seules les différences seront détaillées ici.

La configuration 1100 met en œuvre une deuxième source électrique V destinée à être reliée à l'électrode de garde 108, comme par exemple dans le mode de réalisation 200.

Le dispositif comprend une pluralité d'électrodes de mesure $106_1$-$106_N$ reliées respectivement à un commutateur électronique (switch) d'électrodes 1001 par des pistes de liaison 1002. Le commutateur électronique (switch) d'électrodes 1001 fonctionne comme expliqué dans le mode de réalisation 1000.

Le dispositif comprend également une pluralité d'électrodes de garde $108_1$-$108_N$ disposées respectivement en regard des électrodes de mesure $106_1$-$106_N$. Ces électrodes de garde $108_1$-$108_N$ sont reliées individuellement par des pistes de liaison à un commutateur d'électrodes de garde 1101 dont le fonctionnement est expliqué plus loin.

Les électrodes de mesure $106_1$-$106_N$ et les électrodes garde $108_1$-$108_N$ sont représentées de manière schématique selon une vue en coupe. Elles sont disposées de part et d'autre d'une couche 118, formée par un matériau diélectrique élastiquement compressible.

De manière optionnelle, le dispositif comprend également des secondes électrodes de garde 902 disposés entre les électrodes de garde $108_1$-$108_N$. Ces secondes électrodes de garde sont reliées, comme décrit précédemment, à l'entrée positive de l'AO 110 pour être maintenue au même potentiel que la ou les électrodes de mesure $106_1$-$106_N$.

Suivant le mode de réalisation illustré, les électrodes de garde $108_1$-$108_N$ ont une dimension (par exemple en largeur et/ou en longueur) inférieure à la dimension des électrodes de mesure $106_1$-$106_N$ en regard, de sorte qu'une électrode de mesure soit face à plusieurs électrodes de garde.

Le commutateur d'électrodes de garde 1101 est relié à la sortie de la deuxième source électrique V. Il permet d'appliquer sélectivement la différence de potentiel V1 générée par la deuxième source électrique V à une électrode de garde $108_1$-$108_N$ particulière. Ce commutateur d'électrodes 1001 est en outre agencé de sorte que chaque électrode de garde $108_1$-$108_N$ est reliée, soit à la deuxième source électrique V pour constituer une électrode de garde excitée, soit à un potentiel identique ou sensiblement identique à celui appliqué à la ou les électrodes de mesure. De préférence, une seule électrode de garde excitée est sélectionnée à la fois.

Suivant un exemple de mode de mise en œuvre, lors de la mesure du deuxième signal pour obtenir la capacité électrode-garde $C_{eg}$ (et donc la pression) :

- On sélectionne une électrode de mesure $106_1$ avec le commutateur d'électrodes 1001 (l'électrode de mesure active) ;
- On sélectionne une électrode de garde $108_1$ présente en regard de l'électrode de mesure active avec le commutateur d'électrodes 1001 (l'électrode de garde excitée) ;
- On effectue une mesure du deuxième signal pour obtenir la capacité électrode-garde $C_{eg}$ entre l'électrode de mesure active et l'électrode de garde excitée

Si les électrodes de mesure $106_1$-$106_N$ sont déformables, on peut ainsi obtenir une mesure de pression avec une résolution spatiale qui correspond à la dimension spatiale des électrodes de garde $108_1$-$108_N$, et qui est donc meilleure que la résolution spatiale atteignable avec les électrodes de mesure $106_1$-$106_N$.

Ce mode de réalisation présente donc l'avantage de permettre une résolution spatiale meilleure pour la mesure de la capacité électrode-garde $C_{eg}$ que pour la mesure de la capacité électrode-objet $C_{oe}$. On peut ainsi conserver des électrodes de mesure $106_1$-$106_N$ avec une surface plus étendue qui permettent une meilleure sensibilité pour les mesures de distances avec une résolution spatiale raisonnable, et une résolution spatiale plus fine pour les mesures de pression pour lesquelles la résolution spatiale est importante.

Dans cette configuration, il est possible d'avoir plusieurs électrodes de garde $108_1$-$108_N$ reliées entre elles, chacune étant en regard d'une électrode de mesure $106_1$-$106_N$ différente. Dans la mesure où les électrodes de mesure $106_1$-$106_N$ sont « interrogées » séquentiellement on obtient la même résolution spatiale pour les mesures de pression ou d'appui, tout en limitant le nombre de pistes ou de voies nécessaires pour le commutateur d'électrodes de garde 1101.

Suivant des modes de réalisation, les électrodes de garde $108_1$-$108_N$ peuvent s'étendre en regard de plusieurs électrodes de mesure $106_1$-$106_N$, au moins selon une direction. Dans ce cas, selon la direction perpendiculaire, elles peuvent :

- s'étendre selon une seule électrode de mesure (avec donc une dimension sensiblement égale à celle des électrodes de mesure) ;

- s'étendre selon plusieurs électrodes de mesure (avec donc une dimension supérieure à celle des électrodes de mesure) ;
- ou, comme décrit précédemment, avoir une dimension inférieure à celle des électrodes de mesure, de sorte à avoir plusieurs électrodes de garde en regard d'une électrode de mesure.

Cela permet notamment de limiter le nombre de voies nécessaires pour le commutateur d'électrodes de garde 1101 sans dégrader excessivement la résolution spatiale de la mesure de pression qui est déterminée par la surface de recouvrement entre l'électrode de mesure active (telle que sélectionnée par le commutateur électronique d'électrodes 1001) et l'électrode de garde excitée (telle que sélectionnée par le commutateur d'électrodes de garde 1101).

Le commutateur d'électrodes de garde 1101 peut également être mis en œuvre avec toutes les configurations qui mettent en œuvre une deuxième source électrique V destinée à être reliée à l'électrode de garde 108, comme par exemple dans les modes de réalisation 200 et 500. Lorsqu'un commutateur 302 destiné à connecter ou déconnecter la deuxième source électrique V est mis en œuvre, le commutateur d'électrodes de garde 1101 est inséré entre les électrodes de garde $108_1$-$108_N$ et ce commutateur 302.

Suivant des modes de réalisation, le dispositif peut comprendre des électrodes de garde $108_1$-$108_N$ décalées ou en recouvrement partiel par rapport aux électrodes de mesure $106_1$-$106_N$, et/ou qui s'étendent respectivement en regard de plusieurs électrodes de mesure $106_1$-$106_N$, de sorte à permettre la mesure d'un déplacement de cisaillement du matériau diélectrique 118 par mesure d'une variation de surface de recouvrement entre au moins une desdites électrodes de mesure $106_1$-$106_N$ et au moins une desdites électrode de garde $108_1$-$108_N$. Cette disposition permet notamment de mesurer une composante tangentielle, de cisaillement, d'un appui exercé sur la surface de détection 104. Bien entendu, le dispositif peut également comprendre des électrodes de garde $108_1$-$108_N$ en regard respectivement d'une seule électrode de mesure $106_1$-$106_N$, qui sont donc insensibles à cette composante de cisaillement (ou réciproquement des électrodes de mesure $106_1$-$106_N$ en regard respectivement d'une seule électrode de garde $108_1$-$108_N$). On peut ainsi déduire, à partir de mesures effectuées avec une pluralité d'électrodes, les composantes tangentielles et perpendiculaires (ou radiale) d'une pression exercé sur la surface de détection 104.

Par exemple, le dispositif peut comprendre au moins une électrode de garde 108 en regard de deux électrodes de mesure 106 voisines. En présence d'un déplacement de cisaillement pur dans la direction de recouvrement, la capacité électrode-garde $C_{eg}$ entre l'une des électrodes de mesure 106 et cette électrode de garde 108 augmente du fait de l'augmentation des surfaces en regard, tandis que la capacité électrode-garde $C_{eg}$ entre l'autre électrode de mesure 106 et cette même électrode de garde 108 diminue.

Bien sûr, l'invention n'est pas limitée aux exemples qui viennent d'être décrits et de nombreux aménagements peuvent être apportés à ces exemples sans sortir du cadre de l'invention.

**Revendications**

1. Dispositif (100;200;400;500;600;1000 ;1100) de détection d'un objet (102) par rapport à une surface de détection (104), ledit dispositif (100;200; 400;500;600;1000) comprenant :

   - au moins une électrode de mesure (106) ;
   - au moins une électrode (108), dite de garde ; et
   - une électronique de mesure pour mesurer un signal relatif à la capacité électrique de ladite électrode de mesure (106) ;

   lesdites électrodes de mesure et de garde (106,108) étant séparées d'une distance (D) élastiquement modifiable localement, par une pression exercé par ledit objet (102) sur ladite surface de détection (104) ;
   ledit dispositif comprenant en outre des moyens de polarisation électrique des électrodes (V, E, 302, 402) agencés pour appliquer aux électrodes de mesure et de garde (106,108) :

   - un même premier potentiel électrique alternatif ($V_g$), ou
   - des premiers potentiels alternatifs sensiblement identiques ;

   différent(s) d'un potentiel de masse (M), de sorte à mesurer un premier signal relatif à la capacité ($C_{eo}$), dite électrode-objet, entre ladite électrode de mesure (106) et ledit objet (102), représentatif d'une approche et/ou d'un contact dudit objet (102) avec ladite surface de détection (104) ;
   **caractérisé en ce que** lesdits moyens de polarisation électrique des électrodes (V, E, 302, 402) sont en outre agencés pour appliquer entre les électrodes de mesure et de garde (106,108) une différence de potentiel électrique alternative (V1), de sorte à mesurer un deuxième signal relatif à la capacité ($C_{eg}$), dite électrode-garde, entre lesdites électrodes (106, 108), représentatif d'un appui, ou d'une pression, exercé(e) par ledit objet (102) sur ladite surface de détection (104).

2. Dispositif (100;200;400;500;1000;1100) selon la revendication 1, **caractérisé en ce que** les moyens de polarisation électrique des électrodes (V, E, 302, 402, 116) sont agencés de sorte à générer un premier potentiel électrique alternatif ($V_g$) et une différence de potentiel électrique (V1) satisfaisant au moins l'un des critères suivants :

- le premier potentiel électrique alternatif ($V_g$) et la différence de potentiel électrique (V1) comprennent respectivement au moins une composante fréquentielle à une fréquence différente ;
- le premier potentiel électrique alternatif ($V_g$) et la différence de potentiel électrique (V1) comprennent des signaux orthogonaux entre eux.

3. Dispositif (100;200;400;500;600;1000;1100) selon l'une des revendications 1 ou 2, **caractérisé en ce qu'**il comprend une électronique de mesure avec au moins un moyen de démodulation (115) mettant en œuvre l'un au moins des éléments suivants :

- un démodulateur synchrone ;
- un détecteur d'amplitude ;
- un démodulateur numérique.

4. Dispositif (100;200;1000;1100) selon la revendication 3, **caractérisé en ce qu'**il comprend un premier moyen de démodulation (115) exploitant le premier potentiel électrique alternatif ($V_g$) pour déterminer le premier signal, et un second moyen de démodulation (115) exploitant la différence de potentiel électrique alternative (V1) pour déterminer le deuxième signal.

5. Dispositif (100;200;400;500;1000;1100) selon l'une des revendications précédentes, **caractérisé en ce que** les moyens de polarisation électrique des électrodes (V, E, 302, 402) sont agencés pour générer une différence de potentiel électrique alternative (V1) avec une amplitude différente de l'amplitude du premier potentiel électrique alternatif ($V_g$).

6. Dispositif (100;200;400;500;600;1000;1100) selon l'une quelconque des revendications précédentes, **caractérisé en ce que** les moyens de polarisation électrique des électrodes comprennent une première source électrique (E) référencée en entrée au potentiel de masse (M) et fournissant le premier potentiel électrique alternatif ($V_g$).

7. Dispositif (600) selon la revendication 6, **caractérisé en ce que** la première source électrique (E) est électriquement reliée en sortie à l'au moins une électrode de garde (108), les moyens de polarisation électrique des électrodes comprenant en outre un premier commutateur de source (402) permettant de polariser électriquement l'au moins une électrode de mesure (106) soit au premier potentiel électrique alternatif ($V_g$), soit au potentiel de masse (M).

8. Dispositif (100;200;400;500;1000;1100) selon l'une quelconque des revendications 1 à 6, **caractérisé**

**en ce que** les moyens de polarisation électrique des électrodes comprennent une deuxième source électrique (V) fournissant entre ses bornes la différence de potentiel électrique alternative (V1), laquelle deuxième source de tension (V) étant référencée en entrée au premier potentiel électrique alternatif ($V_g$), et étant agencée en sortie selon l'une des configurations suivantes :

- de sorte à appliquer la différence de potentiel électrique alternative (V1) à l'au moins une électrode de garde (108) ;
- de sorte à appliquer la différence de potentiel électrique alternative (V1) à l'au moins une électrode de mesure (106).

9. Dispositif (400;500) selon l'une des revendications précédentes, **caractérisé en ce que** les moyens de polarisation électrique des électrodes comprennent au moins l'un des commutateurs (402, 302) suivants :

- un premier commutateur (402) agencé de sorte à permettre d'appliquer à l'au moins une électrode de garde (108) et à l'au moins une électrode de mesure (106), soit le potentiel de masse (M), soit le premier potentiel électrique alternatif ($V_g$) ;
- un second commutateur (302) agencé de sorte à permettre d'appliquer entre l'au moins une électrode de garde (108) et l'au moins une électrode de mesure (106), soit la différence de potentiel électrique alternative (V1), soit une différence de potentiel nulle ou sensiblement nulle.

10. Dispositif (100;200;400;500;600;1000;1100) selon l'une quelconque des revendications précédentes, **caractérisé en ce qu'**il comprend au moins un module de calcul configuré pour :

- déterminer une distance ou un contact entre l'objet (102) et la surface de détection (104) en fonction du premier signal ; et/ou
- déterminer une pression ou une force appliquée par ledit objet (102) sur la surface de détection en fonction du deuxième signal.

11. Dispositif (100;200;400;500;600;1000;1100) selon l'une quelconque des revendications précédentes, **caractérisé en ce qu'**il comprend au moins une électrode de mesure (106) et au moins une électrode de garde (108) séparées par une couche (118) élastiquement compressible, comprenant ou formée par, un matériau diélectrique.

12. Dispositif (100;200;400;500;600;1000 ;1100) selon l'une quelconque des revendications précédentes, **caractérisé en ce qu'**il comprend au moins une électrode de mesure (106) disposée sur, ou dans, ou sous, un support, réalisé en un matériau souple, tel qu'un tissu, placé au-dessus et à distance d'au moins une électrode de garde (108), et se déformant au moins localement lorsqu'une pression est exercée sur ledit support.

13. Dispositif (100;200;400;500;600;1000 ;1100) selon l'une quelconque des revendications précédentes, **caractérisé en ce qu'**il comprend plusieurs électrodes de mesure ($106_1$-$106_N$).

14. Dispositif (100;200;400;500;600;1000 ;1100) selon la revendication 13, **caractérisé en ce qu'**il comprend une ou des électrodes de garde agencées selon au moins l'une des configurations suivantes :

   - au moins une électrode de garde (108) disposée en regard de plusieurs, en particulier de toutes les, électrodes de mesure ($106_1$-$106_N$) ;
   - pour au moins une, en particulier chaque, électrode de mesure ($106_1$-$106_N$), une électrode de garde ($108_1$-$108_n$) disposée en regard de ladite électrode de mesure ($106_1$-$106_N$) ;
   - pour au moins une, en particulier chaque, électrode de mesure ($106_1$-$106_N$), plusieurs électrodes de garde ($108_1$-$108_n$) disposées en regard de ladite électrode de mesure ($106_1$-$106_N$).

15. Dispositif (1000;1100) selon l'une quelconque des revendications précédentes, **caractérisé en ce qu'** il comprend en outre au moins une seconde électrode de garde (902) polarisée à un potentiel identique au potentiel de la ou des électrodes de mesure (106).

16. Dispositif (1000 ;1100) selon l'une quelconque des revendications précédentes, **caractérisé en ce qu'** il comprend plusieurs électrodes de mesure ($106_1$-$106_N$), et un commutateur d'électrodes (1001) permettant de relier sélectivement une électrode de mesure ($106_1$-$106_N$), dite électrode active, à l'électronique de mesure, ledit commutateur d'électrode (1001) étant en outre agencé pour polariser les autres électrodes de mesures ($106_1$-$106_N$) au même potentiel électrique que l'électrode active.

17. Dispositif (1100) selon l'une des revendications 13 à 16, comprenant une deuxième source électrique (V) agencée de sorte à appliquer la différence de potentiel électrique alternative (V1) à une pluralité d' électrodes de garde ($108_1$-$108_n$), **caractérisé en ce qu'**il comprend en outre un commutateur d'électrodes de garde (1101) permettant de relier sélectivement une ou une pluralité d'électrodes de garde ($106_1$-$106_N$), dite électrode(s) de garde excitée(s), à la deuxième source de tension (V), ledit commutateur d'électrode (1101) étant en outre agencé pour polariser les autres électrodes de garde ($108_1$-$108_N$)

au même potentiel électrique que l'électrode active.

18. Dispositif (100;200;400;500;600;1000 ;1100) selon l'une quelconque des revendications précédentes, **caractérisé en ce que** l'électronique de mesure comprend un circuit implémentant un amplificateur opérationnel (110) avec une impédance comprenant une composante capacitive (112) en contre réaction, la ou les électrodes de mesure (106) étant reliées à l'entrée négative dudit amplificateur opérationnel.

19. Dispositif (100;200;400;500;600;1000 ;1100) selon la revendication 16, **caractérisé en ce que** le circuit implémentant un amplificateur opérationnel (110) est alimenté par une alimentation électrique référencée au premier potentiel électrique alternatif ($V_g$).

20. Procédé de détection d'un objet (102) par rapport à une surface de détection (104), mettant en œuvre un dispositif de détection (100;200;400;500; 600;1000 ;1100) selon l'une quelconque des revendications précédentes, ledit procédé comprenant au moins une itération des étapes suivantes :

   - une première étape de détection d'approche et/ou de contact de l'objet (102) relativement à ladite surface de détection (104) comprenant les opérations suivantes :
   - une application aux électrodes de mesure (106) et de garde (108) :

      • d'un même premier potentiel électrique alternatif ($V_g$), ou
      • de premiers potentiels alternatifs sensiblement identique(s) ; différent(s) d'un potentiel de masse (M) ;

   - une mesure d'un premier signal relatif à la capacité ($C_{eo}$), dite électrode-objet, entre ladite électrode de mesure (106) et ledit objet (102), représentatif d'une approche et/ou d'un contact dudit objet (102) avec ladite surface de détection (104) ;
   - une deuxième étape de détection d'appui dudit objet (102) sur ladite surface de détection (104) comprenant les opérations suivantes :

      • une application, entre les électrodes de mesure (106) et de garde (108), d'une différence de potentiel électrique alternative (V1), et
      • une mesure d'un deuxième signal relatif à la capacité ($C_{eg}$), dite électrode-garde, entre lesdites électrodes de mesure (106) et de garde (108), représentatif d'un appui, ou d'une pression, exercé(e) par ledit objet (102) sur ladite surface de détection (104).

**21.** Procédé selon la revendication précédente, **caractérisé en ce que** le dispositif de détection comprend une pluralité d'électrodes de mesures, la deuxième étape de détection étant réalisée uniquement dans une zone de la surface de détection (104) dans laquelle l'objet (102) a été détecté lors de la première étape de détection.

**22.** Procédé selon l'une des revendications 20 ou 21, **caractérisé en ce qu'**il comprend une étape de calibrage comprenant :

- une détection d'approche et/ou de contact ;
- en l'absence d'objet détecté, une détection d'appui de sorte à déterminer une capacité électrode-garde dite de calibrage.

**23.** Procédé selon la revendication 22, **caractérisé en ce qu'**il comprend une étape de vérification fonctionnelle comprenant une comparaison d'une capacité électrode-garde de calibrage avec une capacité électrode-garde nominale ou une gamme de capacité électrode-garde nominales.

**24.** Couche de détection, pour équipement, équipée d'un dispositif (100;200;400;500;600 ;1000 ;1100) selon l'une quelconque des revendications 1 à 19.

**25.** Équipement, équipé d'un dispositif de détection (100;200;400;500;600;1000 ;1100) selon l'une quelconque des revendications 1 à 19.


**Patentansprüche**

**1.** Vorrichtung (100;200;400;500;600;1000;1100) zur Detektion eines Objektes (102) in Bezug auf eine Detektionsfläche (104), wobei die Vorrichtung (100;200;400;500;600;1000) umfasst:

- mindestens eine Messelektrode (106);
- mindestens eine sogenannte Schutzelektrode (108); und
- eine Messelektronik zum Messen eines Signals, das die elektrische Kapazität der Messelektrode betrifft (106);

wobei die Mess- und die Schutzelektroden (106, 108) mit einem Abstand (D) getrennt sind, der lokal elastisch durch einen Druck veränderbar ist, der von dem Objekt (102) auf die Detektionsfläche (104) ausgeübt wird;
wobei die Vorrichtung ferner Mittel zur elektrischen Polarisation der Elektroden (V, E, 302, 402) umfasst, die eingerichtet sind, um an die Mess- und die Schutzelektroden (106, 108) anzulegen:

- ein gleiches erstes elektrisches Wechselpotential ($V_g$), oder
- erste Wechselpotentiale, die im Wesentlichen identisch sind;

das/die sich von einem Massepotential (M) unterscheidet/unterscheiden, derart, dass ein erstes Signal, das die sogenannte Elektroden-Objekt-Kapazität ($C_{eo}$) zwischen der Messelektrode (106) und dem Objekt (102) betrifft, gemessen wird, das für eine Annäherung und/oder einen Kontakt des Objekts (102) mit der Detektionsfläche (104) repräsentativ ist;
**dadurch gekennzeichnet, dass** die Mittel zur elektrischen Polarisation der Elektroden (V, E, 302, 402) ferner eingerichtet sind, um zwischen den Mess- und den Schutzelektroden (106, 108) eine elektrische Wechselpotentialdifferenz (V1) anzulegen, derart, dass ein zweites Signal, das die sogenannte Schutzelektrodenkapazität ($C_{eg}$) zwischen den Elektroden (106, 108) betrifft, gemessen wird, das für ein Aufliegen oder einen Druck repräsentativ ist, das/der durch das Objekt (102) auf die Detektionsfläche (104) ausgeübt wird.

**2.** Vorrichtung (100;200;400;500;1000;1100) nach Anspruch 1, **dadurch gekennzeichnet, dass** die Mittel zur elektrischen Polarisation der Elektroden (V,E, 302,402,116) derart gestaltet sind, dass sie ein erstes elektrisches Wechselpotential ($V_g$) und eine elektrische Potentialdifferenz (V1) erzeugen, die mindestens eines der folgenden Kriterien erfüllen:

- das erste elektrische Wechselpotential ($V_g$) und die elektrische Potentialdifferenz (V1) umfassen jeweils mindestens eine Frequenzkomponente mit einer unterschiedlichen Frequenz;
- das erste elektrische Wechselpotential ($V_g$) und die elektrische Potentialdifferenz (V1) umfassen zueinander orthogonale Signale.

**3.** Vorrichtung (100;200;400;500;600;1000;1100) nach einem der Ansprüche 1 oder 2, **dadurch gekennzeichnet, dass** sie eine Messelektronik mit mindestens einem Demodulationsmittel (115) umfasst, das mindestens eines der folgenden Elemente ausführt:

- einen Synchrondemodulator;
- einen Amplitudendetektor;
- einen digitalen Demodulator.

**4.** Vorrichtung (100;200;1000;1100) nach Anspruch 3, **dadurch gekennzeichnet, dass** sie ein erstes Demodulationsmittel (115), das das erste elektrische Wechselpotential ($V_g$) nutzt, um das erste Signal zu bestimmen, und ein zweites Demodulationsmittel (115) umfasst, das die elektrische Wechselpotentialdifferenz (V1) nutzt, um das zweite Signal zu bestimmen.

5. Vorrichtung (100;200;400;500;1000;1100) nach einem der vorhergehenden Ansprüche, **dadurch gekennzeichnet, dass** die Mittel zur elektrischen Polarisation der Elektroden (V,E,302,402) eingerichtet sind, um eine elektrische Wechselpotentialdifferenz (V1) mit einer Amplitude zu erzeugen, die sich von der Amplitude des ersten elektrischen Wechselpotentials ($V_g$) unterscheidet.

6. Vorrichtung (100;200;400;500;600;1000;1100) nach einem der vorhergehenden Ansprüche, **dadurch gekennzeichnet, dass** die Mittel zur elektrischen Polarisation der Elektroden eine erste elektrische Quelle (E) umfassen, die am Eingang auf das Massepotential (M) bezogen ist und das erste elektrische Wechselpotential ($V_g$) liefert.

7. Vorrichtung (600) nach Anspruch 6, **dadurch gekennzeichnet, dass** die erste elektrische Quelle (E) am Ausgang mit mindestens einer Schutzelektrode (108) elektrisch verbunden ist, wobei die Mittel zur elektrischen Polarisation der Elektroden ferner einen ersten Quellenschalter (402) umfassen, der das elektrische Polarisieren von mindestens einer Messelektrode (106) entweder auf dem ersten elektrischen Wechselpotential ($V_g$) oder auf dem Massepotential (M) ermöglicht.

8. Vorrichtung (100;200;400;500;1000;1100) nach einem der Ansprüche 1 bis 6, **dadurch gekennzeichnet, dass** die Mittel zur elektrischen Polarisation der Elektroden eine zweite elektrische Quelle (V) umfassen, die zwischen ihren Anschlüssen die elektrische Wechselpotentialdifferenz (V1) liefert, wobei die zweite Spannungsquelle (V) am Eingang auf das erste elektrische Wechselpotential ($V_g$) bezogen ist und am Ausgang gemäß einer der folgenden Ausgestaltungen eingerichtet ist:

- derart, dass die elektrische Wechselpotentialdifferenz (V1) an die mindestens eine Schutzelektrode (108) angelegt wird;
- derart, dass die elektrische Wechselpotentialdifferenz (V1) an die mindestens eine Messelektrode (106) angelegt wird.

9. Vorrichtung (400;500) nach einem der vorhergehenden Ansprüche, **dadurch gekennzeichnet, dass** die Mittel zur elektrischen Polarisation der Elektroden mindestens einen von den folgenden Schaltern (402, 302) umfassen:

- einen ersten Schalter (402), der derart eingerichtet ist, dass er das Anlegen von entweder dem Massepotential (M) oder dem ersten elektrischen Wechselpotential ($V_g$) an mindestens eine Schutzelektrode (108) und an mindestens eine Messelektrode (106) ermöglicht;
- einen zweiten Schalter (302), der derart eingerichtet ist, dass er das Anlegen von entweder der elektrischen Wechselpotentialdifferenz (V1) oder einer Potentialdifferenz von null oder im Wesentlichen null an mindestens eine Schutzelektrode (108) und mindestens eine Messelektrode (106) ermöglicht.

10. Vorrichtung (100;200;400;500;600;1000;1100) nach einem der vorhergehenden Ansprüche, **dadurch gekennzeichnet, dass** sie mindestens ein Rechenmodul umfasst, das ausgestaltet ist zum:

- Bestimmen eines Abstands oder eines Kontakts zwischen dem Objekt (102) und der Detektionsfläche (104) in Abhängigkeit von dem ersten Signal; und/oder
- Bestimmen eines Drucks oder einer Kraft, die von dem Objekt (102) auf die Detektionsfläche angewandt wird, in Abhängigkeit von dem zweiten Signal.

11. Vorrichtung (100;200;400;500;600;1000;1100) nach einem der vorhergehenden Ansprüche, **dadurch gekennzeichnet, dass** sie mindestens eine Messelektrode (106) und mindestens eine Schutzelektrode (108) umfasst, die von einer Schicht (118) getrennt sind, die elastisch zusammendrückbar ist und ein dielektrisches Material umfasst oder daraus besteht.

12. Vorrichtung (100;200;400;500;600;1000;1100) nach einem der vorhergehenden Ansprüche, **dadurch gekennzeichnet, dass** sie mindestens eine Messelektrode (106) umfasst, die auf oder in oder unter einem Träger angeordnet ist, der aus einem biegsamen Material, wie beispielsweise einem Gewebe, hergestellt ist, über und in einem Abstand von mindestens einer Schutzelektrode (108) platziert ist und sich zumindest lokal verformt, wenn ein Druck auf den Träger ausgeübt wird.

13. Vorrichtung (100;200;400;500;600;1000;1100) nach einem der vorhergehenden Ansprüche, **dadurch gekennzeichnet, dass** sie mehrere Messelektroden ($106_1$ bis $106_N$) umfasst.

14. Vorrichtung (100;200;400;500;600;1000;1100) nach Anspruch 13, **dadurch gekennzeichnet, dass** sie eine oder mehrere der Schutzelektroden umfasst, die gemäß mindestens einer der folgenden Ausgestaltungen eingerichtet ist bzw. sind:

- mindestens eine Schutzelektrode (108), die mehreren, insbesondere sämtlichen Messelektroden ($106_1$ bis $106_N$) gegenüberstehend angeordnet ist;

- für mindestens eine, insbesondere jede Messelektrode ($106_1$ bis $106_N$), eine Schutzelektrode ($108_1$ bis $108_n$), die der Messelektrode ($106_1$b bis $106_N$) gegenüberstehend angeordnet ist;

- für mindestens eine, insbesondere jede Messelektrode ($106_1$ bis $106_N$), mehrere Schutzelektroden ($108_1$ bis $108_n$), die der Messelektrode ($106_1$ bis $106_N$) gegenüberstehend angeordnet sind.

15. Vorrichtung (1000;1100) nach einem der vorhergehenden Ansprüche, **dadurch gekennzeichnet, dass** sie ferner mindestens eine zweite Schutzelektrode (902) umfasst, die mit einem Potential polarisiert ist, das identisch mit dem Potential der einen oder mehreren Messelektroden (106) ist.

16. Vorrichtung (1000;1100) nach einem der vorhergehenden Ansprüche, **dadurch gekennzeichnet, dass** sie mehrere Messelektroden ($106_1$ bis $106_N$) und einen Elektrodenschalter (1001) umfasst, der das selektive Verbinden einer Messelektrode ($106_1$ bis $106_N$), der sogenannten aktiven Elektrode, mit der Messelektronik ermöglicht, wobei der Elektrodenschalter (1001) ferner eingerichtet ist, um die anderen Messelektroden ($106_1$ bis $106_N$) mit dem gleichen elektrischen Potential zu polarisieren wie die aktive Elektrode.

17. Vorrichtung (1100) nach einem der Ansprüche 13 bis 16, die eine zweite elektrische Quelle (V) umfasst, die derart eingerichtet ist, dass sie die elektrische Wechselpotentialdifferenz (V1) an mehrere Schutzelektroden ($108_1$ bis $108_n$) anlegt, **dadurch gekennzeichnet, dass** sie ferner einen Schutzelektrodenschalter (1101) umfasst, der das selektive Verbinden von einer oder mehreren Schutzelektroden ($106_1$ bis $106_N$), der/den sogenannten angeregten Schutzelektrode/n, mit der zweiten Spannungsquelle (V) ermöglicht, wobei der Elektrodenschalter (1101) ferner eingerichtet ist, um die anderen Schutzelektroden ($108_1$ bis $108_N$) mit dem gleichen elektrischen Potential zu polarisieren wie die aktive Elektrode.

18. Vorrichtung (100;200;400;500;600;1000;1100) nach einem der vorhergehenden Ansprüche, **dadurch gekennzeichnet, dass** die Messelektronik eine Schaltung umfasst, die einen Operationsverstärker (110) mit einer Impedanz implementiert, die eine kapazitive Komponente (112) in Gegenreaktion umfasst, wobei die eine oder mehreren Messelektroden (106) mit dem negativen Eingang des Operationsverstärkers verbunden sind.

19. Vorrichtung (100;200;400;500;600;1000;1100) nach Anspruch 16, **dadurch gekennzeichnet, dass** die Schaltung, die einen Operationsverstärker (110) implementiert, durch eine elektrische Versorgung versorgt wird, die auf das erste elektrische Wechselpotential ($V_g$) bezogen ist.

20. Verfahren zur Detektion eines Objekts (102) in Bezug auf eine Detektionsfläche (104), das eine Detektionsvorrichtung (100; 200; 400; 500; 600; 1000; 1100) nach einem der vorhergehenden Ansprüche einsetzt, wobei das Verfahren mindestens eine Iteration der folgenden Schritte umfasst:

- eines ersten Schritts des Detektierens der Annäherung und/oder des Kontakts des Objekts (102) in Bezug auf die Detektionsfläche (104), der die folgenden Vorgänge umfasst:

- ein Anlegen von Folgendem an die Mess- (106) und die Schutzelektroden (108):

• eines gleichen ersten elektrischen Wechselpotentials ($V_g$), oder
• (eines) ersten/erster Wechselpotentials/Wechselpotentiale, das/die im Wesentlichen identisch ist/sind;

das/die sich von dem Massepotential (M) unterscheidet/unterscheiden;

- eine Messung eines ersten Signals, das die sogenannte Elektroden-Objekt-Kapazität ($C_{eo}$) zwischen der Messelektrode (106) und dem Objekt (102) betrifft und das für eine Annäherung und/oder einen Kontakt des Objekts (102) an die/mit der Detektionsfläche (104) repräsentativ ist;

- eines zweiten Schritts des Detektierens des Aufliegens des Objekts (102) auf der Detektionsfläche (104), der die folgenden Vorgänge umfasst:

• ein Anlegen einer elektrischen Wechselpotentialdifferenz (V1) zwischen den Mess- (106) und den Schutzelektroden (108), und
• eine Messung eines zweiten Signals, das die sogenannte Schutzelektrodenkapazität ($C_{eg}$) zwischen den Mess- (106) und den Schutzelektroden (108) betrifft und das für ein Aufliegen oder einen Druck repräsentativ ist, das/der von dem Objekt (102) auf die Detektionsfläche (104) ausgeübt wird.

21. Verfahren nach dem vorhergehenden Anspruch, **dadurch gekennzeichnet, dass** die Detektionsvorrichtung mehrere Messelektroden umfasst, wobei der zweite Detektionsschritt einzig in einer Zone der Detektionsfläche (104) ausgeführt wird, in der das Objekt (102) im ersten Detektionsschritt detektiert wurde.

22. Verfahren nach einem der Ansprüche 20 oder 21, **dadurch gekennzeichnet, dass** es einen Kalibrierungsschritt umfasst, der umfasst:

- eine Detektion der Annäherung und/oder des Kontakts;
- bei Nichtvorhandensein eines detektierten Objekts, eine Detektion des Aufliegens, derart, dass eine Kapazität der sogenannten Kalibrierungsschutzelektrode bestimmt wird.

23. Verfahren nach Anspruch 22, **dadurch gekennzeichnet, dass** es einen Schritt der Funktionsüberprüfung umfasst, der einen Vergleich einer Kalibrierungsschutzelektrodenkapazität mit einer Nennschutzelektrodenkapazität oder einem Nennschutzelektrodenkapazitätsbereich umfasst.

24. Detektionsschicht für Ausrüstungen, die mit einer Vorrichtung (100;200;400;500;600;1000;1100) nach einem der Ansprüche 1 bis 19 ausgerüstet ist.

25. Ausrüstung, die mit einer Detektionsvorrichtung (100;200;400;500;600;1000;1100) nach einem der Ansprüche 1 bis 19 ausgerüstet ist.

**Claims**

1. A device (100;200;400;500;600;1000;1100) for detecting an object (102) with respect to a detection surface (104), said device (100;200;400; 500;600;1000) comprising:

- at least one measurement electrode (106);
- at least one electrode (108), called guard electrode; and
- a measurement electronics for measuring a signal with respect to the electrical capacitance of said measurement electrode (106);

said measurement and guard electrodes (106, 108) being separated by a distance (D) that is elastically modifiable locally, by a load exerted by said object (102) on said detection surface (104);
said device also comprising means for electrical polarization of the electrodes (V,E,302,402) arranged in order to apply to the measurement and guard electrodes (106, 108):

- one and the same first alternating electrical potential ($V_g$), or
- first, substantially identical, alternating potentials;

that is(are) different from a ground potential (G), so as to measure a first signal with respect to the capacitance ($C_{eo}$), called electrode-object capacitance, between said measurement electrode (106) and said object (102), representative of an approach and/or a contact of said object (102) with said detection surface (104);
**characterized in that** said means for electrical polarization of the electrodes (V,E,302,402) are also arranged to apply between the measurement and guard electrodes (106, 108) an alternating electrical potential difference (V1), so as to measure a second signal with respect to the capacitance ($C_{eg}$), called electrode-guard capacitance, between said electrodes (106, 108), representative of a pressure or a load, exerted by said object (102) on said detection surface (104).

2. The device (100;200;400;500;1000;1100) according to claim 1, **characterized in that** the means for electrical polarization of the electrodes (V,E, 302,402, 116) are arranged so as to generate a first alternating electrical potential ($V_g$) and an electrical potential difference (V1) satisfying at least one of the following criteria:

- the first alternating electrical potential ($V_g$) and the electrical potential difference (V1) comprise respectively at least one frequency component at a different frequency;
- the first alternating electrical potential ($V_g$) and the electrical potential difference (V1) comprise signals that are orthogonal to one another.

3. The device (100;200 400;500;600;1000;1100) according to one of claims 1 or 2, **characterized in that** it comprises measurement electronics with at least one demodulation means (115) utilizing at least one of the following elements:

- a synchronous demodulator;
- an amplitude detector;
- a digital demodulator.

4. The device (100;200;1000;1100) according to claim 3, **characterized in that** it comprises a first demodulation means (115) exploiting the first alternating electrical potential ($V_g$) in order to determine the first signal, and a second demodulation means (115) exploiting the alternating electrical potential difference (V1) in order to determine the second signal.

5. The device (100;200;400;500;1000;1100) according to one of the preceding claims, **characterized in that** the means for electrical polarization of the electrodes (V,E,302,402) are arranged in order to generate an alternating electrical potential difference (V1) with an amplitude different from the amplitude of the first alternating electrical potential ($V_g$).

6. The device (100;200;400;500;600;1000;1100) according to any one of the preceding claims, **characterized in that** the means for electrical polarization of the electrodes comprise a first electrical source (E) referenced at the input to the ground potential (G) and supplying the first alternating electrical potential ($V_g$).

7. The device (600) according to claim 6, **characterized in that** the first electrical source (E) is electrically connected at the output to the at least one guard electrode (108), the means for electrical polarization of the electrodes also comprising a first source switch (420) making it possible to electrically polarize the at least one measurement electrode (106) either at the first alternating electrical potential ($V_g$) or at the ground potential (G).

8. The device (100;200;400;500;1000;1100) according to any one of claims 1 to 6, **characterized in that** the means for electrical polarization of the electrodes comprise a second electrical source (V) supplying between its terminals the alternating electrical potential difference (V1), said second voltage source (V) being referenced at the input to the first alternating electrical potential ($V_g$), and being arranged at the output according to one of the following configurations:

 - so as to apply the alternating electrical potential difference (V1) to the at least one guard electrode (108);
 - so as to apply the alternating electrical potential difference (V1) to the at least one measurement electrode (106).

9. The device (400;500) according to one of the preceding claims, **characterized in that** the means for electrical polarization of the electrodes comprise at least one of the following switches (402,302):

 - a first switch (402) arranged so as to make it possible to apply to the at least one guard electrode (108) and to the at least one measurement electrode (106), either the ground potential (G) or the first alternating electrical potential ($V_g$);
 - a second switch (302) arranged so as to make it possible to apply between the at least one guard electrode (108) and the at least one measurement electrode (106), either the alternating electrical potential difference (V1), or a zero or substantially zero potential difference.

10. Device (100;200;400;500;600;1000;1100) according to any one of the preceding claims, **characterized in that** it comprises at least one calculation module configured in order to:

 - determine a distance or a contact between the object (102) and the detection surface (104) as a function of the first signal; and/or
 - determine a load or a pressure applied by said object (102) on the detection surface as a function of the second signal.

11. The device (100;200;400;500;600;1000;1100) according to any one of the preceding claims, **characterized in that** it comprises at least one measurement electrode (106) and at least one guard electrode (108) separated by a layer (118) that is elastically compressible, comprising or formed by a dielectric material.

12. The device (100;200;400;500;600;1000;1100) according to any one of the preceding claims, **characterized in that** it comprises at least one measurement electrode (106) placed on, or in, or under, a support, produced from a flexible material, such as a fabric, placed above and at a distance from at least one guard electrode (108), and deforming at least locally when a load is exerted on said support.

13. The device (100;200;400;500;600;1000;1100) according to any one of the preceding claims, **characterized in that** it comprises several measurement electrodes ($106_1$-$106_N$).

14. The device (100;200;400;500;600;1000;1100) according to claim 13, **characterized in that** it comprises one or more guard electrodes arranged according to at least one of the following configurations:

 - at least one guard electrode (108), placed opposite several, in particular all, the measurement electrodes ($106_1$-$106_N$);
 - for at least one, in particular each, measurement electrode ($106_1$-$106_N$), a guard electrode ($108_1$-$108_N$) placed opposite said measurement electrode ($106_1$-$106_N$);
 - for at least one, in particular each, measurement electrode ($106_1$-$106_N$), several guard electrodes ($108_1$-$108_N$) placed opposite said measurement electrode ($106_1$-$106_N$).

15. The device (1000;1100) according to any one of the preceding claims, **characterized in that** it also comprises at least one second guard electrode (902) polarized at a potential identical to the potential of the measurement electrode or electrodes (106).

16. The device (1000;1100) according to any one of the preceding claims, **characterized in that** it comprises several measurement electrodes ($106_1$-$106_N$), and an electrode switch (1001) making it possible to selectively connect a measurement electrode ($106_1$-$106_N$), called "active electrode", to the measurement electronics, said electrode switch (1001) also being arranged in order to polarize the other measurement electrodes ($106_1$-$106_N$) at the same electrical potential as the active electrode.

17. The device (1100) according to one of claims 13 to 16, comprising a second electrical source (V) arranged so as to apply the alternating electrical potential difference (V1) to a plurality of guard electrodes ($108_1$-$108_N$), **characterized in that** it also comprises a guard electrode switch (1101) making it possible to selectively connect one or a plurality of guard electrodes ($106_1$-$106_N$), called "excited guard electrode or electrodes", to the second voltage source (V), said electrode switch (1101) also being arranged in order to polarize the other guard electrodes ($108_1$-$108_N$) at the same electrical potential as the active electrode.

18. The device (100;200;400;500;600;1000;1100) according to any one of the preceding claims, **characterized in that** the measurement electronics comprise a circuit utilizing an operational amplifier (110) with an impedance comprising a feedback capacitive component (112), the measurement electrode or electrodes (106) being connected to the negative input of said operational amplifier.

19. **The** device (100;200;400;500;600;1000;1100) according to claim 16, **characterized in that** the circuit utilizing an operational amplifier (110) is supplied by an electrical supply referenced to the first alternating electrical potential ($V_g$).

20. A method for the detection of an object (102) with respect to a detection surface (104) utilizing a detection device (100;200;400;500;600;1000;1100) according to any one of the preceding claims, said method comprising at least one iteration of the following steps:

- a first step of detecting the approach and/or contact of the object (102) with respect to said detection surface (104) comprising the following operations:

- application to the measurement (106) and guard (108) electrodes:

• of one and the same first alternating electrical potential ($V_g$), or
• first alternating potentials that are substantially identical;

that is(are) different from a ground potential (G);

- measuring a first signal with respect to the capacitance ($C_{eo}$), called electrode-object capacitance, between said measurement electrode (106) and said object (102), representative of an approach and/or a contact of said object (102) with said detection surface (104);

- a second step of detecting pressure of said object (102) on said detection surface (104) comprising the following operations:

• applying, between the measurement (106) and guard (108) electrodes, an alternating electrical potential difference (V1), and
• measuring a second signal with respect to the capacitance ($C_{eg}$), called electrode-guard capacitance, between said measurement (106) and guard (108) electrodes, representative of a pressure or a load, exerted by said object (102) on said detection surface (104).

21. The method according to the preceding claim, **characterized in that** the detection device comprises a plurality of measurement electrodes, the second detection step being carried out only in an area of the detection surface (104) in which the object (102) was detected during the first detection step.

22. The method according to one of claims 20 or 21, **characterized in that** it comprises a calibration step comprising:

- detecting approach and/or contact;
- in the absence of a detected object, detecting pressure so as to determine an electrode-guard capacitance called "calibration capacitance".

23. The method according to claim 22, **characterized in that** it comprises a step of functional verification comprising a comparison of an electrode-guard calibration capacitance with a nominal electrode-guard capacitance or a range of nominal electrode-guard capacitances.

24. A detection layer, for an item of equipment, equipped with a device (100;200;400;500;600;1000;1100) according to any one of claims 1 to 19.

25. A item of equipment, equipped with a detection device (100;200;400;500;600;1000;1100) according to any one of claims 1 to 19.

FIG.1

FIG.2

FIG.3

FIG.4

FIG.5

FIG.6

FIG.7

FIG.8

FIG.9

FIG.10

**EP 3 556 016 B1**

## RÉFÉRENCES CITÉES DANS LA DESCRIPTION

**Documents brevets cités dans la description**

- WO 2013093326 A1